# EUROPÄISCHE PATENTANMELDUNG

(11) **EP 4 277 049 A2**
(43) Veröffentlichungstag der Anmeldung: **15.11.2023**
(21) Anmeldenummer: 23154373.7
(22) Anmeldetag: 01.02.2023
(51) Int. Cl.: H01S 5/00

(54) **VERFAHREN UND VORRICHTUNG ZUM STABILISIEREN VON ELEKTROMAGNETISCHER STRAHLUNG EINES OPTISCHEN OSZILLATORS**

(30) Priorität: 01.02.2022 DE 102022102272
(71) Anmelder: Menlo Systems GmbH, 82152 Martinsried (DE)
(72) Erfinder: Lilienfein, Nikolai, 80337 München (DE); Hänsel, Wolfgang, 81369 München (DE); Holzwarth, Ronald, 82194 Gröbenzell (DE); Holzberger, Simon, 90587 Veitsbronn (DE); Fischer, Marc, 80636 München (DE); Böhle, Frederik, 81375 München (DE)
(74) Vertreter: Grünecker Patent- und Rechtsanwälte PartG mbB

(57) **Zusammenfassung**

Das Stabilisieren von einer elektromagnetischen Strahlung (1) eines optischen Oszillators (3), insbesondere eines Lasers (13), umfasst ein Messen einer Abweichung (35, 37, 43) zwischen der elektromagnetischen Strahlung (1) des optischen Oszillators (3) und einer Referenz (21, 23, 39, 41) und Erzeugen eines ersten Abweichungssignals (35, 37, 43), Ansteuern eines ersten Reglers (55) mit dem ersten Abweichungssignal (35, 37, 43), Regeln des ersten Abweichungssignals (35, 37, 43, 38) mittels Ansteuerung zumindest einer ersten Stellgröße (5, 7, 89) von zumindest zwei Stellgrößen (5, 7, 89), wobei die erste Stellgröße (5, 7, 89) durch ein erstes Ausgangssignal (57) des ersten Reglers (55) angesteuert wird und die erste Stellgröße (5, 7, 89) auf die erste elektromagnetische Strahlung (1) des optischen Oszillators (3) einwirkt, sowie Erzeugen eines Modulationssignals (65) mit einer Modulationseinheit (63), und Ansteuern der ersten oder einer zweiten Stellgröße (5, 7, 89) mit dem Modulationssignal (65), Demodulieren des ersten Ausgangssignals (57) des ersten Reglers (55) mit dem Modulationssignal (65) und Erzeugen eines zweiten Abweichungssignals (71) von einem Festwert (73), Ansteuern eines zweiten Reglers (74) mit dem zweiten Abweichungssignal (71) und Ansteuern einer der Stellgrößen (5, 7, 89) mit einem Ausgangssignal (75) des zweiten Reglers (74) und Regeln des zweiten Abweichungssignals (71).

## Beschreibung

Die Erfindung bezieht sich auf ein Verfahren sowie auf eine Vorrichtung, insbesondere eine Regelungsvorrichtung, zum Stabilisieren von einer ersten elektromagnetischen Strahlung eines optischen Oszillators, insbesondere eines ersten Lasers, mit den Merkmalen gemäß dem Oberbegriff der Ansprüche 1, 14 bzw. 15.

Verfahren oder Vorrichtungen, insbesondere Regelvorrichtungen, der oben genannten Art finden vielfach Anwendung in spektroskopischen Verfahren, wie etwa Absorptionsspektroskopie an Atomen oder Molekülen, oder in medizinischen Verfahren. Hierbei ist zumindest das Erzeugen von elektromagnetischer Strahlung mit einer möglichst geringen Wellenlängenabweichung oder Frequenzabweichung von einer Referenz erwünscht. Dabei ist es von besonderem Interesse, schon bestehende Verfahren oder Vorrichtungen, insbesondere Regelvorrichtungen, weiter zu verbessern, um eine bessere Stabilisierung von elektromagnetischer Strahlung eines optischen Oszillators, insbesondere eines Lasers, zu erreichen. Auch soll hierfür eine möglichst einfache Implementierung erreicht werden, um einen möglichst allgemeinen Nutzen zu ermöglichen.

So beschreibt Chiow et al. "Extended-cavity diode lasers with tracked resonances", Applied Optics, Volume 46, Seite 7997, Veröffentlichungsjahr 2007, das Modulieren einer Stellgröße eines Diodenlasers, die Messung des Intensitäts- oder Frequenzrauschens der elektromagnetischen Strahlung des Diodenlasers sowie die Regelung des Intensitäts- oder Frequenzrauschens durch Ansteuerung der Stellgröße, um eine Stabilisierung der Strahlung des Diodenlasers zu erreichen.

Die US 2009/0262762 A1 sowie die US 6,687,269 B1 beschreiben das Modulieren einer Stellgröße eines Lasers, die Messung von dessen Lichtintensität, sowie die Steuerung des Lasers um die Lichtintensität zu maximieren.

Die US 2008/0159340 A1 beschreibt die Steuerung einer Transmission eines Lasers um eine Stabilisierung der Strahlung des Lasers zu erreichen.

Es ist die Aufgabe der Erfindung, ein Verfahren oder eine Vorrichtung, insbesondere eine Regelungsvorrichtung, zum Stabilisieren von elektromagnetischer Strahlung eines optischen Oszillators, insbesondere eines Lasers, z.B. eines Diodenlasers mit externem Resonator, bereitzustellen, wobei das Verfahren bzw. die Vorrichtung, insbesondere die Regelungsvorrichtung, eine besonders stabile Möglichkeit bereitstellen soll, Strahlung mit zumindest einer möglichst konstanten Wellenlänge oder Frequenz gegenüber einer Referenz zu erzeugensowie Modensprünge, insbesondere des Lasers, z.B. des Diodenlasers mit externem Resonator, zu vermeiden.

Diese Aufgabe wird erfindungsgemäß durch ein Verfahren gemäß Anspruch 1 bzw. 15, sowie durch eine Vorrichtung, insbesondere eine Regelungsvorrichtung, gemäß Anspruch 14 zum Stabilisieren von elektromagnetischer Strahlung eines optischen Oszillators, insbesondere eines Lasers, gelöst.

Die hierbei erzielte technische Wirkung liegt darin, eine verbesserte Stabilisierung von elektromagnetischer Strahlung eines optischen Oszillators, insbesondere eines Lasers, zu erreichen.

Vorzugsweise kann eine von mehreren Stellgrößen mit einem Ausgangssignal eines Reglers angesteuert werden und ein Frequenz- oder Phasenabweichungssignal der elektromagnetischen Strahlung des optischen Oszillators geregelt werden.

Weiter vorzugsweise kann ein Verhältnis aus Modulationsindizes, insbesondere aus Frequenz- oder Phasenmodulationsindizes von zumindest zwei Stellgrößen gemessen werden und ein Abweichungssignal aus einer Abweichung des Verhältnisses von einem Festwert gebildet werden und weiterhin eine der Stellgrößen mit einem Ausgangssignal eines Reglers angesteuert werden und das Abweichungssignal oder das Verhältnis geregelt werden. Hierdurch können Voraussetzungen geschaffen werden, einen Dynamikbereich für zumindest eine Stellgröße des optischen Oszillators bereitzustellen.

Weiter vorzugsweise kann ein Frequenz- oder Phasenmodulationsindex von zumindest einer Stellgröße gemessen werden und ein Abweichungssignal aus einer Abweichung des Frequenz- oder Phasenmodulationsindex von einem Festwert gebildet werden und weiterhin die Stellgröße mit einem Ausgangssignal eines Reglers angesteuert werden und das Abweichungssignal geregelt werden. Hierdurch können Voraussetzungen geschaffen werden, einen Dynamikbereich für zumindest eine Stellgröße des optischen Oszillators bereitzustellen.

Ein Modulationsindex bezeichnet dabei das Verhältnis aus dem Ansteuern einer Stellgröße und der Wirkung der Stellgröße auf die elektromagnetische Strahlung. Entsprechend bezeichnet ein Frequenzmodulationsindex ein Ansteuern einer Stellgröße und die Wirkung der Stellgröße auf eine Frequenz der elektromagnetischen Strahlung. Weiter entsprechend bezeichnet ein Phasenmodulationsindex ein Ansteuern einer Stellgröße und die Wirkung der Stellgröße auf eine Phase der elektromagnetischen Strahlung.

Vorteilhafterweise kann durch eine Regelung eines Verhältnisses zwischen einem Modulationsindex einer zweiten Stellgröße und einem Modulationsindex einer ersten Stellgröße ein gro-ßer Dynamikbereich für eine Frequenz- oder Phasenregelung des optischen Oszillators bereitgestellt werden. Dadurch kann eine verbesserte Stabilisierung der elektromagnetischen Strahlung des optischen Oszillators, insbesondere des Lasers, erreicht werden.

Im Folgenden kann eine elektromagnetische Strahlung, beispielsweise erzeugt von einem Laser oder von verschiedenen Referenzquellen aber auch von anderen Quellen oder Generatoren, welche eine elektromagnetische Strahlung erzeugen können, zumindest eine Frequenz oder gleichbedeutend zumindest eine Wellenlänge umfassen und kann die elektromagnetische Strahlung zumindest auch eine Phase umfassen. Wenn also ein Bilden einer Differenz zwischen verschiedenen elektromagnetischen Strahlungen beschrieben wird, so kann hiermit ein Bilden einer Frequenzdifferenz und/oder einer Phasendifferenz gemeint sein. Hierbei kann eine elektromagnetische Strahlung erzeugt werden, welche zumindest die vorgenannte Frequenzdifferenz und/oder Phasendifferenz umfassen kann. Wenn ein Verstellen der elektromagnetischen Strahlung beschrieben wird, kann hiermit insbesondere ein Verstellen der Frequenz und/oder der Phase der elektromagnetischen Strahlung gemeint sein. Es kann aber auch ein Verstellen einer Amplitude der elektromagnetischen Strahlung gemeint sein, insbesondere ein Verstellen einer Feldgröße oder einer Leistung, wobei die Feldgröße eine Spannung, ein Strom, ein elektrisches Feld oder ein magnetisches Feld umfassen kann.

Ein Regeln der elektromagnetischen Strahlung kann sinngemäß ein Regeln der zumindest einen Frequenz oder der zumindest einen Wellenlänge umfassen und/oder kann weiterhin ein Regeln von zumindest der einen Phase umfassen.

Weiterhin wird im Folgenden der Begriff einer Wellenlänge und einer Frequenz mit dem Bewusstsein genutzt, dass Wellenlänge und Frequenz in der fundamentalen Relation zueinanderstehen, nach der ein Produkt aus Wellenlänge und Frequenz einer Geschwindigkeit entspricht, wobei die Geschwindigkeit die Lichtgeschwindigkeit sein kann. Hierbei kann die Lichtgeschwindigkeit die Lichtgeschwindigkeit in einem Vakuum sein oder kann die Lichtgeschwindigkeit die Lichtgeschwindigkeit in einem Medium sein, wobei das Medium durch einen Brechungsindex charakterisiert sein kann und die Lichtgeschwindigkeit in dem Medium langsamer sein kann als die Lichtgeschwindigkeit im Vakuum, wobei eine Verlangsamung der Lichtgeschwindigkeit in dem Medium gegenüber der Lichtgeschwindigkeit im Vakuum dadurch quantifiziert sein kann, die Lichtgeschwindigkeit im Vakuum durch den Brechungsindex zu teilen.

Vorzugsweise können alle in der erfindungsgemäßen Vorrichtung, insbesondere in der Regelvorrichtung, bzw. alle in dem erfindungsgemäßen Verfahren vorgesehenen Stellgrößen von zumindest einem Regler angesteuert werden, auch wenn dies nicht explizit erwähnt ist. Eine Stellgröße kann im Allgemeinen von mehreren Steuersignalen, insbesondere von einem oder mehreren Reglern, angesteuert werden. Bei Ansteuerung einer Stellgröße mit mehreren Steuersignalen, können die Steuersignale überlagert werden, insbesondere addiert werden. Somit kann also insbesondere jede vorgesehene Stellgröße zum Stabilisieren der elektromagnetischen Strahlung des optischen Oszillators, insbesondere eines Lasers, verwendet werden. Eine Ansteuerung kann direkt erfolgen, kann aber auch indirekt erfolgen, etwa über eine zweite Ansteuerung anderer Komponenten der Vorrichtung oder des Verfahrens. Eine Stellgröße kann im Allgemeinen dazu ausgebildet sein, auf eine elektromagnetische Strahlung einzuwirken zum Einstellen der elektromagnetischen Strahlung. Insbesondere kann eine Stellgröße dazu ausgebildet sein, auf eine Frequenz und/oder Phase der elektromagnetischen Strahlung einzuwirken zum Einstellen der Frequenz und/oder Phase der elektromagnetischen Strahlung.

Vorzugsweise kann das erfindungsgemäße Verfahren zum Stabilisieren von einer ersten elektromagnetischen Strahlung eines optischen Oszillators, insbesondere eines ersten Lasers, ein Messen einer Abweichung zwischen der ersten elektromagnetischen Strahlung des optischen Oszillators und einer Referenz und Erzeugen eines ersten Abweichungssignals umfassen, und kann weiterhin ein Ansteuern eines ersten Reglers mit dem ersten Abweichungssignal, ein Regeln des ersten Abweichungssignals mittels Ansteuerung zumindest einer ersten Stellgröße von zumindest zwei Stellgrößen, wobei die erste Stellgröße durch ein erstes Ausgangssignal des ersten Reglers angesteuert werden kann und die erste Stellgröße auf die erste elektromagnetische Strahlung des optischen Oszillators einwirken kann, sowie ein Erzeugen eines Modulationssignals mit einer Modulationseinheit, und Ansteuern der ersten oder einer zweiten Stellgröße mit dem Modulationssignal, ein Demodulieren des ersten Ausgangssignals des ersten Reglers mit dem Modulationssignal und Erzeugen eines zweiten Abweichungssignals von einem Festwert, ein Ansteuern eines zweiten Reglers mit dem zweiten Abweichungssignal und ein Ansteuern einer der Stellgrößen mit einem Ausgangssignal des zweiten Reglers und Regeln des zweiten Abweichungssignals umfassen.

Wie vorstehend schon beschrieben, kann hierbei ein Regeln des ersten Abweichungssignals mittels Ansteuerung zumindest einer ersten Stellgröße von zumindest zwei Stellgrößen umfassen, dass das Ansteuern mit einem oder mehreren Steuersignalen erfolgen kann.

In einer Ausführungsform kann das Verfahren umfassen, das erste Abweichungssignal mittels Ansteuerung von zumindest zwei Stellgrößen zu regeln, wobei die zwei Stellgrößen jeweils durch zumindest ein Ausgangssignal des ersten Reglers angesteuert werden können und die zwei Stellgrößen auf die erste elektromagnetische Strahlung des optischen Oszillators einwirken können. In einer bevorzugten Ausführungsform kann die Abweichung minimiert werden.

In einer bevorzugten Ausführungsform kann die Referenz eine zweite elektromagnetische Strahlung eines zweiten Lasers umfassen und kann die Abweichung als Differenz zwischen der ersten elektromagnetischen Strahlung und der zweiten elektromagnetischen Strahlung gebildet werden.

In einer bevorzugten Ausführungsform kann die Referenz eine Radiofrequenzreferenz und eine zweite elektromagnetische Strahlung eines zweiten Lasers umfassen und kann die Abweichung als Differenz zwischen einerseits einer Differenz der ersten elektromagnetischen Strahlung und der zweiten elektromagnetischen Strahlung, und andererseits der Radiofrequenzreferenz gebildet werden.

In einer bevorzugten Ausführungsform kann die Abweichung eine Frequenzabweichung oder eine Phasenabweichung umfassen.

In einer Ausführungsform kann der zweite Laser ein Dauerstrichlaser sein.

Der zweite Laser kann als ein Sagnac Laser ausgebildet sein.

In einer Ausführungsform kann der zweite Laser ein gepulster Laser sein.

In einer Ausführungsform kann der zweite Laser ein Frequenzkammlaser sein.

In einer Ausführungsform kann die zweite elektromagnetische Strahlung ein durch elektrooptische Modulation erzeugter Frequenzkamm sein.

In einer Ausführungsform kann die zweite elektromagnetische Strahlung ein durch nichtlineare Frequenzkonversion erzeugter Frequenzkamm sein.

In einer bevorzugten Ausführungsform kann die Referenz einen Resonator umfassen und kann die Abweichung eine Frequenzabweichung oder eine Phasenabweichung zwischen einer Frequenz oder Phase der ersten elektromagnetischen Strahlung und einer Frequenz oder Phase des Resonators umfassen.

In einer bevorzugten Ausführungsform kann der Resonator eine Güte in einem Bereich zwischen 10000 und 1000000 umfassen, wobei die Güte gleich einer Frequenz des Resonators dividiert durch eine Frequenzbandbreite des Resonators sein kann. Der Resonator kann vorzugsweise ULE (ultra-low expansion) Abstandshalter (spacer) umfassen.

Vorteilhafterweise kann der Resonator eine Güte in einem Bereich zwischen 50000 und 700000 umfassen, wobei die Güte gleich einer Frequenz des Resonators dividiert durch eine Frequenzbandbreite des Resonators sein kann und der Resonator vorzugsweise ULE (ultra-low expansion) Abstandshalter (spacer) umfassen kann. Weiter vorteilhafterweise kann der Resonator eine Güte in einem Bereich zwischen 100000 und 500000 umfassen. Weiter vorteilhafterweise kann der Resonator eine Güte in einem Bereich zwischen 300000 und 500000 umfassen.

In einer bevorzugten Ausführungsform kann der Resonator einen Etalon umfassen. Der Etalon kann verschieden und entsprechend seiner Funktion in dem Verfahren und/oder dem Resonator ausgeführt sein. Dabei kann der Etalon insbesondere ein Fabry-Perot-Etalon sein.

In einer bevorzugten Ausführungsform kann der Resonator ein Interferometer umfassen.

Das Interferometer kann als ein Faser-Interferometer, insbesondere als ein Faser-Freiraum-Interferometer, ausgebildet sein.

Das Interferometer kann als ein Freistrahl-Interferometer ausgebildet sein.

Das Interferometer kann als ein Fizeau-Interferometer ausgebildet sein.

Das Interferometer kann als ein Fabry-Perot-Interferometer ausgebildet sein.

Das Interferometer kann als ein Sagnac-Interferometer ausgebildet sein.

Das Interferometer kann als ein Michelson-Interferometer ausgebildet sein. Das Michelson-Interferometer kann zwei Interferometerarme unterschiedlicher Länge umfassen, insbesondere unterschiedlicher optischer oder geometrischer Länge.

In einer bevorzugten Ausführungsform kann die Referenz ein atomares oder molekulares Gas umfassen und die Abweichung eine Frequenzabweichung oder eine Phasenabweichung zwischen einer Frequenz oder Phase der ersten elektromagnetischen Strahlung und einer Frequenz oder Phase einer Resonanz des atomaren oder molekularen Gases umfassen. Eine Messung der Frequenzabweichung oder der Phasenabweichung kann Sättigungsspektroskopie oder Ramsey-Spektroskopie umfassen.

In einer Ausführungsform kann die Referenz einen Atomstrahl oder ein Atomstrahlinterferometer umfassen und die Abweichung eine Frequenzabweichung oder eine Phasenabweichung zwischen einer Frequenz oder Phase der ersten elektromagnetischen Strahlung und einer Frequenz oder Phase einer Resonanz des Atomstrahls oder Atomstrahlinterferometers umfassen.

In einer Ausführungsform kann die Referenz lasergekühlte Atome oder Ionen umfassen und die Abweichung eine Frequenzabweichung oder eine Phasenabweichung zwischen einer Frequenz oder Phase der ersten elektromagnetischen Strahlung und einer Frequenz oder Phase einer Resonanz der Atome oder Ionen umfassen.

In einer bevorzugten Ausführungsform kann die Referenz ein Frequenz- oder Phasenmessinstrument umfassen, insbesondere ein Wavemeter oder ein Interferometer, und die Abweichung eine Frequenzabweichung oder eine Phasenabweichung zwischen einer Frequenz oder Phase der ersten elektromagnetischen Strahlung und einer Frequenz oder Phase des Frequenz- oder Phasenmessinstruments umfassen.

In einer bevorzugten Ausführungsform kann der optische Oszillator die Stellgrößen umfassen und einen Halbleiterlaser umfassen, insbesondere einen Diodenlaser, und können die Stellgrößen den Diodenstrom des Diodenlasers umfassen und/oder die Diodentemperatur des Diodenlasers umfassen.

Der Diodenlaser kann mit einem externen Resonator ausgeführt sein. Die Frequenz und/oder Phase der ersten elektromagnetischen Strahlung kann bezüglich einem Referenzsystem stabilisiert sein. Das Referenzsystem kann einen optischen Oszillator umfassen, wobei der optische Oszillator des Referenzsystems als referenzbildende Komponente ausgeführt sein kann.

Die erste elektromagnetische Strahlung des Diodenlasers mit externem Resonator kann mittels einer elektromagnetischen Strahlung eines Frequenzkamms bezüglich des Referenzsystems stabilisiert sein.

Der Diodenlaser kann eine Laserdiode umfassen, wobei die Laserdiode mit einer Antireflexbeschichtung ausgeführt sein kann. Die Antireflexbeschichtung kann einen Reflektionsgrad in einem Bereich zwischen 1×10^-5 und 1×10^-1 umfassen. Die Antireflexbeschichtung kann einen Reflektionsgrad in einem Bereich zwischen 1×10^-3 und 1×10^-1 umfassen.

Der Diodenlaser kann eine Laserdiode umfassen, wobei die Laserdiode antireflexbeschichtungsfrei ausgeführt sein kann.

In einer Ausführungsform kann der optische Oszillator einen distributed Bragg reflector (DBR) oder distributed feedback (DFB) Halbleiterlaser umfassen.

In einer Ausführungsform kann der optische Oszillator einen optisch gepumpten Halbleiterlaser umfassen, und können die Stellgrößen die optische Leistung eine Pumplasers umfassen. Insbesondere kann der optisch gepumpte Halbleiterlaser ein vertical-external-cavity surface-emitting-laser (VECSEL) sein.

In einer Ausführungsform kann der optische Oszillator als integrierter photonischer Schaltkreis in einem oder mehreren Halbleiterelementen realisiert sein.

In einer Ausführungsform kann der optische Oszillator als heterogen integrierter photonischer Schaltkreis in mehreren Halbleiterelementen realisiert sein.

In einer bevorzugten Ausführungsform kann der optische Oszillator einen Halbleiterlaser umfassen. Der Halbleiterlaser kann eine elektromagnetische Strahlung emittieren, wobei die elektromagnetische Strahlung eine Wellenlänge zwischen 350 nm und 10 Mikrometer umfassen kann, insbesondere zwischen 350 nm und 1500 nm, insbesondere zwischen 350 nm und 550 nm, insbesondere zwischen 600 nm und 800 nm.

In einer bevorzugten Ausführungsform kann der optische Oszillator eine erste Fläche und eine zweite Fläche umfassen, wobei zumindest die erste Fläche oder die zweite Fläche teilweise durchlässig für die erste elektromagnetische Strahlung sein kann, und der optische Oszillator einen verstellbaren Wellenlängenfilter umfassen kann, zum Selektieren zumindest einer Wellenlänge der ersten elektromagnetischen Strahlung.

In einer bevorzugten Ausführungsform können die Stellgrößen zumindest einen Piezoaktuator umfassen, der an die erste Fläche und/oder die zweite Fläche gekoppelt sein kann, um eine Kraft auf die erste Fläche und/oder die zweite Fläche auszuüben, um die Frequenz oder Phase der ersten elektromagnetischen Strahlung einzustellen. Insbesondere kann der Piezoaktuator dazu ausgebildet sein, eine kontinuierliche Einstellung der Frequenz oder Phase der ersten elektromagnetischen Strahlung zu erreichen. In einer Ausführungsform können die Stellgrößen den verstellbaren Wellenlängenfilter umfassen und können dazu ausgebildet sein, den verstellbaren Wellenlängenfilter einzustellen.

In einer Ausführungsform können die Stellgrößen zumindest einen elektro-optischen Modulator umfassen, der in einem Strahlweg des Lasers angeordnet sein kann, um die Frequenz oder Phase der ersten elektromagnetischen Strahlung einzustellen.In einer Ausführungsform kann sich wenigstens eine der Stellgrößen außerhalb des optischen Oszillators befinden und einen akustooptischen Modulator oder einen Frequenzschieber umfassen.

Vorzugsweise kann eine erfindungsgemäße Vorrichtung zum Stabilisieren von einer ersten elektromagnetischen Strahlung eines optischen Oszillators, insbesondere eines ersten Lasers, eine Regelvorrichtung umfassen.

Vorzugsweise kann die Regelvorrichtung eine Messvorrichtung, einen Referenzgenerator zum Erzeugen einer Referenz, einen ersten Regler und einen zweiten Regler umfassen. Insbesondere kann die Messvorrichtung zum Messen einer Abweichung zwischen der ersten elektromagnetischen Strahlung des optischen Oszillators und der Referenz ausgebildet sein, wobei der erste Regler dazu ausgebildet sein kann, von einem ersten Abweichungssignal angesteuert zu werden und das Abweichungssignal über eine Ansteuerung zumindest einer ersten Stellgröße von zumindest zwei Stellgrößen mit einem ersten Ausgangssignal zu regeln.

Vorzugsweise kann die Regelvorrichtung eine Modulationseinheit umfassen, welche dazu ausgebildet sein kann, die erste oder eine zweite Stellgröße mit einem Modulationssignal anzusteuern.

Vorzugsweise kann die Regelvorrichtung eine Demodulationseinheit umfassen, welche dazu ausgebildet sein kann, das erste Ausgangssignal des ersten Reglers mit dem Modulationssignal zu demodulieren und ein zweites Abweichungssignal von einem Festwert zu erzeugen.

Vorzugsweise kann der zweite Regler dazu ausgebildet sein, von dem zweiten Abweichungssignal angesteuert zu werden und eine der Stellgrößen mit einem Ausgangssignal anzusteuern, um das zweite Abweichungssignal zu regeln.

Die Erfindung kann ein Verfahren zum Stabilisieren von einer ersten elektromagnetischen Strahlung eines optischen Oszillators, insbesondere eines Lasers, umfassen, welches ein Messen einer Abweichung zwischen der ersten elektromagnetischen Strahlung des optischen Oszillators und einer Referenz und Erzeugen eines ersten Abweichungssignals umfassen kann. Das Verfahren kann ein Ansteuern eines ersten Reglers mit dem ersten Abweichungssignal umfassen. Das Verfahren kann ein Regeln des ersten Abweichungssignals mittels Ansteuerung zumindest einer ersten Stellgröße von zumindest zwei Stellgrößen, wobei die erste Stellgröße durch ein erstes Ausgangssignal des ersten Reglers angesteuert werden kann und die erste Stellgröße auf die erste elektromagnetische Strahlung des optischen Oszillators einwirken kann umfassen. Insbesondere kann das Verfahren ein Messen eines Modulationsindex, insbesondere eines Frequenz- und/oder Phasenmodulationsindex, zumindest einer der Stellgrößen umfassen. Das Verfahren kann ein Bilden eines zweiten Abweichungssignals aus einer Abweichung des Modulationsindex von einem Festwert umfassen. Das Verfahren kann umfassen einen zweiten Regler mit dem zweiten Abweichungssignal anzusteuern. Das Verfahren kann umfassen eine der Stellgrö-ßen mit einem Ausgangssignal des zweiten Reglers anzusteuern. Das Verfahren kann umfassen das zweite Abweichungssignal oder den Modulationsindex zu regeln, wobei der Modulationsindex ein Verhältnis aus dem Ansteuern zumindest einer der Stellgrößen und der Wirkung der zumindest einen Stellgröße auf die erste elektromagnetische Strahlung ist.

In einer Ausführungsform kann das Verfahren umfassen das erste Abweichungssignal mittels Ansteuerung von zumindest zwei Stellgrößen zu regeln, wobei die zwei Stellgrößen jeweils durch ein Ausgangssignal des ersten Reglers angesteuert werden können und die zwei Stellgrö-ßen auf die erste elektromagnetische Strahlung des optischen Oszillators einwirken können.

Die Erfindung kann ein Verfahren zum Stabilisieren von einer ersten elektromagnetischen Strahlung eines optischen Oszillators, insbesondere eines Lasers umfassen, welches ein Messen einer Abweichung zwischen der ersten elektromagnetischen Strahlung des optischen Oszillators und einer Referenz und Erzeugen eines ersten Abweichungssignals umfassen kann, und weiterhin ein Ansteuern eines ersten Reglers mit dem ersten Abweichungssignal und ein Regeln des ersten Abweichungssignals mittels Ansteuerung zumindest einer ersten Stellgröße von zumindest zwei Stellgrößen, wobei die erste Stellgröße durch ein erstes Ausgangssignal des ersten Reglers angesteuert werden kann und die erste Stellgröße auf die erste elektromagnetische Strahlung des optischen Oszillators einwirken kann. Insbesondere kann das Verfahren ein Erzeugen eines Modulationssignals mit einer Modulationseinheit, und Ansteuern der ersten oder einer zweiten Stellgröße mit dem Modulationssignal umfassen, und kann weiterhin ein Messen eines Verhältnisses aus einem Ansteuern von Stellgrößen und Bilden eines zweiten Abweichungssignals aus einer Abweichung des Verhältnisses von einem Festwert, ein Ansteuern eines zweiten Reglers mit dem zweiten Abweichungssignal und ein Ansteuern einer der Stellgrößen mit einem Ausgangssignal des zweiten Reglers und Regeln des zweiten Abweichungssignals oder des Verhältnisses umfassen.

Ein erfindungsgemäßes Verfahren kann ein Erzeugen eines Phasenabweichungssignals und/oder eines Frequenzabweichungssignals mittels einer Vergleicheinheit zwischen einerseits einer Differenz der elektromagnetischen Strahlung des optischen Oszillators und einer elektromagnetischen Strahlung einer ersten Referenzquelle, und andererseits einer elektromagnetischen Strahlung einer zweiten Referenzquelle umfassen, und kann weiterhin ein Einkoppeln des Phasenabweichungssignals und/oder des Frequenzabweichungssignals in einen ersten Regler und Ansteuern zumindest einer ersten Stellgröße des optischen Oszillators mit zumindest einem Ausgangssignal des ersten Reglers zum Regeln des Phasenabweichungssignals und/oder des Frequenzabweichungssignals, ein Erzeugen einer Modulation und Bilden zumindest einer ersten Überlagerung der Modulation mit einem Ausgangssignal eines zweiten Reglers, ein Ansteuern zumindest einer zweiten, von der ersten verschiedenen Stellgröße des optischen Oszillators mit der zumindest einen ersten Überlagerung, ein Bilden eines Demodulationssignals des Ausgangssignals des ersten Reglers und ein Ansteuern der zumindest einen ersten Stellgröße des optischen Oszillators mit einer anderen, zweiten Überlagerung aus dem Ausgangssignal des ersten Reglers und einem Ausgangssignal eines mit dem Demodulationssignal angesteuerten dritten Reglers und Regeln eines Verhältnisses zwischen dem Ansteuern der zumindest einen zweiten Stellgröße mit der zumindest einen ersten Überlagerung und dem Ansteuern der zumindest einen ersten Stellgröße mit der zweiten Überlagerung umfassen.

Vorteilhafterweise kann das Erzeugen des Phasenabweichungssignals und/oder des Frequenzabweichungssignals mittels der Vergleicheinheit, eine Vorrichtung und/oder ein Verfahren aus dem Stand der Technik zum Erzeugen eines Phasenabweichungssignals und/oder eines Frequenzabweichungssignals umfassen.

Vorteilhafterweise kann das Verfahren vorsehen, eine Phasenabweichung des Phasenabweichungssignals und/oder eine Frequenzabweichung des Frequenzabweichungssignals zwischen der Differenz der elektromagnetischen Strahlung des optischen Oszillators und der elektromagnetischen Strahlung der ersten Referenzquelle, und der elektromagnetischen Strahlung der zweiten Referenzquelle zu minimieren.

Optional kann das Verfahren zum Stabilisieren der elektromagnetischen Strahlung des optischen Oszillators, insbesondere des Lasers, eine Side-of-Fringe Locking Frequenzstabilisierung umfassen, wobei zumindest eine Frequenz des Lasers gegenüber einer Resonanzfrequenz einer Kavität oder einer atomaren oder molekularen Absorptionslinie verstimmt werden kann, wobei hierfür die Kavität mit einem ersten Eingang und einem ersten Ausgang ausgebildet werden kann oder eine Gaszelle mit einem atomaren oder molekularen Gas und einem ersten Eingang und einem ersten Ausgang ausgebildet werden kann, wobei die elektromagnetische Strahlung des optischen Oszillators, insbesondere des Lasers, in den ersten Eingang der Kavität oder in den ersten Eingang der Gaszelle eingekoppelt werden kann und die aus dem ersten Ausgang der Kavität oder dem ersten Ausgang der Gaszelle ausgekoppelte elektromagnetische Strahlung des optischen Oszillators, insbesondere des Laser, von einem Detektor detektiert werden kann. Der Detektor kann insbesondere ein Fotodetektor sein, wobei weiterhin Fluktuationen der zumindest einen Frequenz des Lasers in Intensitätsfluktuationen eines Ausgangssignals des Detektors, insbesondere des Fotodetektors, umgewandelt werden können, wobei die Intensitätsfluktuationen durch eine zusätzlich bereitgestellte Feedbackschleife minimiert werden können, wobei die Feedbackschleife zumindest die erste Stellgröße oder die zweite Stellgröße umfassen kann und weiterhin das Ausgangssignal des Detektors umfassen kann, insbesondere des Fotodetektors umfassen kann.

Optional kann das Verfahren zum Stabilisieren der elektromagnetischen Strahlung des optischen Oszillators, insbesondere des Lasers, eine Top-of-Fringe Locking Frequenzstabilisierung umfassen, wobei die zumindest eine Frequenz des Lasers mit einer Modulationsfrequenz moduliert werden kann. Die elektromagnetische Strahlung des Lasers kann weiterhin von einem Detektor, insbesondere von einem Fotodetektor, an einem Eingang des Detektors, insbesondere des Fotodetektors, detektiert werden, wobei eine Modulation der zumindest einen Frequenz des Lasers dazu führen kann, dass ein Ausgangssignal des Detektors, insbesondere des Fotodetektors, ebenfalls moduliert werden kann. Hierbei kann das Ausgangssignal des Detektors, insbesondere des Fotodetektors, insbesondere mit der Modulationsfrequenz moduliert werden bei der auch die zumindest eine Frequenz des Lasers moduliert wird. Weiterhin kann eine Modulation des Ausgangssignals des Detektors, insbesondere des Fotodetektors, mit der Modulationsfrequenz mit der die zumindest eine Frequenz des Lasers moduliert werden kann, demoduliert werden, zum Erzeugen einer Ableitung eines Signals welches von der elektromagnetischen Strahlung des Lasers an dem Eingang des Detektors, insbesondere des Fotodetektors, erzeugt werden kann.

Die Modulation der zumindest einen Frequenz des Lasers kann zu einem positiven oder negativen Zahlenwert der Ableitung führen, wobei die Top-of-Fringe Locking Frequenzstabilisierung darauf ausgelegt sein kann, den Betrag des Zahlenwerts der Ableitung zu minimieren. Vorzugsweise kann die Top-of-Fringe Locking Frequenzstabilisierung weiterhin eine Feedback-schleife umfassen, wobei die Feedbackschleife einen Eingang und einen Ausgang umfassen kann, wobei der positive oder negative Zahlenwert der Ableitung in den Eingang der Feedback-schleife eingekoppelt werden kann und der Ausgang der Feedbackschleife die erste Stellgröße und/oder die zweite Stellgröße anpassen kann zum Minimieren des Betrags des Zahlenwertes der Ableitung.

In einer vorteilhaften Ausführungsform des Verfahrens kann der optische Oszillator einen Halbleiterlaser umfassen, insbesondere einen Diodenlaser.

Der Diodenlaser kann eine Laserdiode umfassen, wobei die Laserdiode mit einer Antireflexbeschichtung oder ohne eine Antireflexbeschichtung ausgeführt sein kann.

Vorteilhafterweise kann der Halbleiterlaser eine erste Fläche und eine zweite Fläche umfassen.

Weiterhin kann die elektromagnetische Strahlung aus der ersten Fläche und/oder der zweiten Fläche des Halbleiterlasers ausgekoppelt werden, oder kann die die elektromagnetische Strahlung zumindest teilweise aus der ersten Fläche und/oder der zweiten Fläche des Halbleiterlasers ausgekoppelt werden.

Vorteilhafterweise kann die elektromagnetische Strahlung aus der ersten Fläche des Halbleiterlasers ausgekoppelt werden oder kann die elektromagnetische Strahlung zumindest teilweise aus der ersten Fläche des Halbleiterlasers ausgekoppelt werden.

Wenn die elektromagnetische Strahlung aus der ersten Fläche des Halbleiterlasers ausgekoppelt wird, kann die zweite Fläche des Halbleiterlasers reflektierend ausgeführt sein.

Insbesondere kann die zweite Fläche des Halbeleiterlasers zumindest teilweise transmittierend für die elektromagnetische Strahlung ausgebildet sein.

In einer vorteilhaften Ausführungsform des Verfahrens kann der optische Oszillator eine Kavität umfassen, wobei die Kavität eine erste Fläche und eine zweite Fläche umfassen kann, wobei zumindest die erste Fläche der Kavität teilweise durchlässig für die elektromagnetische Strahlung sein kann. Alternativ kann aber auch die zweite Fläche der Kavität teilweise durchlässig für die elektromagnetische Strahlung sein. Weiterhin können sowohl die erste als auch die zweite Fläche der Kavität teilweise durchlässig für die elektromagnetische Strahlung sein.

Insbesondere kann die elektromagnetische Strahlung zumindest eine Wellenlänge umfassen, wobei vorteilhafterweise eine Länge der Kavität größer sein kann als die zumindest eine Wellenlänge der elektromagnetischen Strahlung.

In einer vorteilhaften Ausführungsform kann der optische Oszillator einen verstellbaren Wellenlängenfilter umfassen zum Selektieren der zumindest einen Wellenlänge bzw. zum Selektieren der zumindest einen Frequenz der elektromagnetischen Strahlung, wobei der Wellenlängenfilter in der Kavität ausgebildet sein kann, wobei ein Verstellen des verstellbaren Wellenlängenfilters eine weitere Stellgröße des optischen Oszillators sein kann. Durch den vorgenannten Wellenlängenfilter kann zumindest eine gewünschte Frequenz der elektromagnetischen Strahlung des Lasers oder des Halbleiterlasers, insbesondere des Diodenlasers, selektiert werden oder kann gleichbedeutend zumindest eine gewünschte Wellenlänge der elektromagnetischen Strahlung des Lasers oder des Halbleiterlasers, insbesondere des Diodenlasers, selektiert werden.

Vorteilhafterweise kann der verstellbare Wellenlängenfilter ein Volume-Holographic-Bragg Grating (VHBG) umfassen, wobei ein Selektieren der zumindest einen Wellenlänge der elektromagnetischen Strahlung umfassen kann, das VHBG gegenüber einer Ausbreitungsrichtung der elektromagnetischen Strahlung zu verkippen.

Vorteilhafterweise kann der verstellbare Wellenlängenfilter ein frequenzselektives bzw. wellenlängenselektives Gitter umfassen, wobei ein Selektieren der zumindest einen Wellenlänge der elektromagnetischen Strahlung durch ein Verkippen des frequenzselektiven Gitters gegenüber einer Ausbreitungsrichtung der elektromagnetischen Strahlung erreicht werden kann, oder gleichbedeutend ein Selektieren der zumindest einen Frequenz der elektromagnetischen Strahlung durch ein Verkippen des frequenzselektiven Gitters gegenüber einer Ausbreitungsrichtung der elektromagnetischen Strahlung erreicht werden kann

Vorteilhafterweise kann der verstellbare Wellenlängenfilter einen dielektrischen Filter umfassen, wobei ein Selektieren der zumindest einen Wellenlänge oder ein Selektieren der zumindest einen Frequenz der elektromagnetischen Strahlung umfassen kann, den dielektrischen Filter gegenüber einer Ausbreitungsrichtung der elektromagnetischen Strahlung zu verkippen.

Insbesondere kann ein Selektieren der zumindest einen Wellenlänge oder der zumindest einen Frequenz der elektromagnetischen Strahlung mittels des verstellbaren Wellenlängenfilters umfassen, eine Temperatur des verstellbaren Wellenlängenfilters zu verändern, zum Erreichen einer Ausdehnung oder zum Erreichen eines Zusammenziehens des verstellbaren Wellenlängenfilters, zum Selektieren der zumindest einen Wellenlänge der elektromagnetischen Strahlung, wobei zumindest eine Struktur des verstellbaren Wellenlängenfilters verschoben oder verformt werden kann, wobei eine Länge der zumindest einen Struktur des Wellenlängenfilters auf die zumindest eine Wellenlänge der elektromagnetischen Strahlung angepasst sein kann oder die Länge der Struktur des Wellenlängenfilters auf eine halbe Wellenlänge der elektromagnetischen Strahlung angepasst sein kann oder die Länge der Struktur des Wellenlängenfilters auf ein Viertel der Wellenlänge der elektromagnetischen Strahlung angepasst sein kann. Vorteilhafterweise kann die Länge der Struktur des Wellenlängenfilters auf eine beliebige Länge der Wellenlänge der elektromagnetischen Strahlung angepasst sein.

Ein Verstellen des verstellbaren Wellenlängenfilters kann eine weitere Stellgröße des optischen Oszillators sein.

Vorteilhafterweise kann in dem Verfahren zum Stabilisieren der elektromagnetischen Strahlung die Länge der Kavität verstellbar sein, wobei die erste Fläche und/oder die zweite Fläche der Kavität an einen Aktuator gekoppelt sein kann und der Aktuator dazu ausgebildet sein kann, auf die erste Fläche und/oder die zweite Fläche einzuwirken zum Verstellen der Länge zum Einstellen der zumindest einen Wellenlänge der elektromagnetischen Strahlung, wobei die zumindest zweite Stellgröße ein Einwirken des Aktuators auf die erste Fläche und/oder die zweite Fläche umfassen kann.

Insbesondere kann durch ein Verstellen der Länge der Kavität eine Kopplung zwischen dem Halbleiterlaser, insbesondere dem Diodenlaser, und der Kavität eingestellt werden. Hierbei kann der Halbleiterlaser, insbesondere der Diodenlaser, bei einer vorgegebenen Länge der Kavität eine elektromagnetische Mode oder mehrere elektromagnetische Moden der Kavität anregen, wobei die elektromagnetische Mode oder die mehreren elektromagnetischen Moden die zumindest eine Wellenlänge umfassen kann, wohingegen eine Anregung weiterer Wellenlängen unterdrückt werden kann. Somit kann also ein Einstellen der zumindest einen Wellenlänge der elektromagnetischen Strahlung erreicht werden.

Insbesondere kann der Aktuator auf einem piezoelektrischen Effekt beruhen oder kann der Aktuator ein elektrooptischer Modulator sein.

Vorzugsweise kann die Kavität über ein Temperaturelement heizbar sein zum Verändern der Länge der Kavität mittels thermischer Ausdehnung zum Einstellen der zumindest einen Wellenlänge der elektromagnetischen Strahlung, wobei die durch das Temperaturelement erzeugte thermische Ausdehnung der Kavität eine weitere Stellgröße des optischen Oszillators sein kann.

Vorzugsweise kann die Kavität über ein Temperaturelement kühlbar sein zum Verändern der Länge der Kavität mittels thermischen Zusammenziehens zum Einstellen der zumindest einen Wellenlänge der elektromagnetischen Strahlung, wobei die durch das Temperaturelement erzeugte thermische Zusammenziehung der Kavität eine weitere Stellgröße des optischen Oszillators sein kann.

Das Temperaturelement kann angeordnet sein, nur einen Teilbereich der Kavität zu heizen. Das Temperaturelement kann aber auch angeordnet sein, die Kavität mit einer über die Kavität zumindest weitestgehend homogen verteilten Temperatur zu heizen. Das Temperaturelement kann eine Temperaturmesseinrichtung umfassen zum Regeln der Temperatur der Kavität, insbesondere zu einer Stabilisierung der Temperatur der Kavität.

Vorteilhafterweise kann der Halbleiterlaser durch einen elektrischen Strom elektronisch gepumpt werden. Hierbei kann ein Verändern des Absolutwerts des elektrischen Stroms zu einer Verkürzung oder einer Verlängerung der zumindest einen Wellenlänge der elektromagnetischen Strahlung führen und die zumindest erste Stellgröße kann den elektrischen Strom umfassen.

Vorteilhafterweise kann der Halbleiterlaser heizbar sein zum Verändern einer Geometrie des Halbleiterlasers zum Einstellen der zumindest einen Wellenlänge der elektromagnetischen Strahlung, wobei das Verändern der Geometrie des Halbleiterlasers eine weitere Stellgröße des optischen Oszillators sein kann.

In einer vorteilhaften Ausführungsform kann das Erzeugen des Phasenabweichungssignals und/oder des Frequenzabweichungssignals mittels der Vergleicheinheit zumindest einen Wellenlängenkonvertierungsprozess umfassen zum Erzeugen einer Frequenzdifferenz und/oder einer Phasendifferenz zwischen der elektromagnetischen Strahlung des optischen Oszillators und der elektromagnetischen Strahlung der ersten Referenzquelle.

Hierbei kann der Wellenlängenkonvertierungsprozess durch den analogen Mischer realisiert werden.

Vorteilhafterweise kann die elektromagnetische Strahlung der ersten Referenzquelle von einem Frequenzkamm gebildet werden.

In einer vorteilhaften Ausführungsform kann die elektromagnetische Strahlung der zweiten Referenzquelle verstellbar sein und an die Frequenzdifferenz und/oder die Phasendifferenz zwischen der elektromagnetischen Strahlung des optischen Oszillators und der elektromagnetischen Strahlung der ersten Referenzquelle anpassbar sein.

In einer vorteilhaften Ausführungsform kann die elektromagnetische Strahlung der zweiten Referenzquelle zumindest eine Frequenz umfassen, wobei die Frequenz der elektromagnetischen Strahlung der zweiten Referenzquelle in einem Bereich von 500 kHz bis 10 GHz eingestellt werden kann, vorzugsweise in einem Bereich von 500 kHz bis 1 GHz, vorzugsweise in einem Bereich von 500 kHz bis 3 GHz, vorzugsweise in einem Bereich von 500 kHz bis 5 GHz.

In einer vorteilhaften Ausführungsform kann das erfindungsgemäße Verfahren modifiziert werden, wobei eine Modifikation des erfindungsgemäßen Verfahrens umfasst den zweiten Regler zu deaktivieren, zum Ausschalten des Ausgangssignals des zweiten Reglers, und einen Diodentreiber bereitzustellen, sowie das Ausgangssignal des dritten Reglers mit der Modulation zu überlagern, zum Bilden der ersten Überlagerung, anstatt das Ausgangssignal des dritten Reglers mit dem Ausgangssignal des ersten Reglers zu überlagern, zum Bilden der zweiten Überlagerung, wobei weiterhin ein Ausgangssignal des Diodentreibers mit dem Ausgangssignal des ersten Reglers überlagert werden kann, zum Bilden der zweiten Überlagerung, zum Ansteuern der zumindest einen ersten Stellgröße des optischen Oszillators, wobei das Ausgangssignal des Diodentreibers eine Spannung und/oder ein Strom sein kann, wobei vorzugsweise das Ausgangssignal des Diodentreibers ein Spannungspuls und/oder ein Strompuls sein kann.

Die erfindungsgemäße Vorrichtung kann vorteilhafterweise eine Vergleicheinheit, umfassend einen Wellenlängenkonverter und einen Wellenlängenkomparator, umfassen, und kann weiterhin eine erste Referenzquelle, eine zweite Referenzquelle, einen ersten Regler, zumindest eine erste Stellgröße, wobei der optische Oszillator dazu ausgebildet ist von der ersten Stellgröße angesteuert zu werden, wobei die Vergleicheinheit dazu ausgebildet ist, ein Phasenabweichungssignal und/oder ein Frequenzabweichungssignal zu bilden, wobei der Wellenlängenkonverter dazu ausgebildet ist eine Frequenzdifferenz und/oder eine Phasendifferenz zwischen der elektromagnetischen Strahlung des optischen Oszillators und einer elektromagnetischen Strahlung der ersten Referenzquelle zu bilden und der Wellenlängenkomparator die Frequenzdifferenz und/oder die Phasendifferenz zwischen der elektromagnetischen Strahlung des optischen Oszillators und der elektromagnetischen Strahlung der ersten Referenzquelle mit einer Frequenz und/oder Phase der elektromagnetischen Strahlung der zweiten Referenzquelle vergleicht, um das Phasenabweichungssignal und/oder das Frequenzabweichungssignal zu bilden, wobei weiterhin der erste Regler zum Empfangen des Phasenabweichungssignals und/oder des Frequenzabweichungssignals ausgebildet ist, um die erste Stellgröße mit zumindest einem Ausgangssignal des ersten Reglers anzusteuern, um das Phasenabweichungssignal und/oder das Frequenzabweichungssignal zu regeln umfassen, und eine Modulationseinheit umfassen, um eine Modulation zu erzeugen, und kann eine erste Überlagerungseinheit umfassen, um zumindest eine erste Überlagerung der Modulation mit einem Ausgangssignal eines zweiten Reglers zu bilden. Weiterhin kann die erfindungsgemäße Vorrichtung eine zweite Stellgröße umfassen, wobei der optische Oszillator dazu ausgebildet sein kann von der zweiten Stellgröße angesteuert zu werden und die zumindest zweite Stellgröße kann dazu ausgebildet sein, von der ersten Überlagerung angesteuert zu werden. Insbesondere kann die erfindungsgemäße Vorrichtung eine Demodulationseinheit umfassen, welche dazu ausgebildet sein kann, ein Demodulationssignal aus dem Ausgangssignal des ersten Reglers zu bilden, wobei die Demodulationseinheit weiterhin dazu ausgebildet sein kann, einen dritten Regler mit dem Demodulationssignal anzusteuern, um ein Ausgangssignal des mit dem Demodulationssignal angesteuerten dritten Reglers zu bilden. Vorzugsweise kann die erfindungsgemäße Vorrichtung eine zweite Überlagerungseinheit umfassen, die dazu konfiguriert sein kann, die zumindest eine erste Stellgröße des optischen Oszillators mit einer zweiten Überlagerung anzusteuern, wobei die zweite Überlagerungseinheit dazu ausgebildet sein kann, die zweite Überlagerung aus dem Ausgangssignal des ersten Reglers und des Ausgangssignals des mit dem Demodulationssignal angesteuerten dritten Reglers zu bilden. Insbesondere kann die erfindungsgemäße Vorrichtung eine Regeleinheit umfassen, welche dazu ausgebildet sein kann, ein Verhältnis zwischen einem Ansteuern der zweiten Stellgröße und einem Ansteuern der ersten Stellgröße zu regeln.

In einer vorteilhaften Ausführungsform der Vorrichtung kann ein verstellbarer Wellenlängenfilter in einer Kavität des Oszillators angeordnet sein, um zumindest eine Wellenlänge der elektromagnetischen Strahlung zu selektieren, wobei der verstellbare Wellenlängenfilter eine weitere Stellgröße des optischen Oszillators sein kann.

In einer alternativen vorteilhaften Ausführungsform kann die erfindungsgemäße Vorrichtung modifiziert werden, wobei eine Modifikation der erfindungsgemäßen Vorrichtung die Vorrichtung ohne den zweiten Regler und ohne das Ausgangssignal des zweiten Reglers umfasst und weiterhin einen Diodentreiber umfassen kann, wobei der Diodentreiber dazu konfiguriert sein kann, ein Ausgangssignal zu erzeugen, wobei das Ausgangssignal des Diodentreibers eine Spannung und/oder einen Strom umfassen kann, wobei vorteilhafterweise das Ausgangssignal des Diodentreibers ein Spannungspuls und/oder ein Strompuls umfassen kann, wobei die Modifikation weitergehend die erste Überlagerungseinheit umfassen kann, wobei die erste Überlagerungseinheit dazu ausgebildet sein kann, die Modulation der Modulationseinheit mit dem Ausgangssignal des dritten Reglers zu überlagern, um zumindest eine erste Überlagerung zu bilden, anstatt die zweite Überlagerungseinheit dazu auszubilden das Ausgangssignal des ersten Reglers mit dem Ausgangssignal des dritten Reglers zu überlagern, um die zweite Überlagerung zu bilden, wobei die Modifikation weitergehend die zweite Überlagerungseinheit umfassen kann, wobei die zweite Überlagerungseinheit dazu ausgebildet sein kann, das Ausgangssignal des Diodentreibers mit dem Ausgangssignal des ersten Reglers zu überlagern, um die zweite Überlagerung zu bilden, um die zumindest eine erste Stellgröße des optischen Oszillators anzusteuern.

Der Diodentreiber kann zum Ansteuern eines Lasers ausgebildet sein und kann als interne Komponente des Lasers ausgebildet sein. Vorzugsweise kann der Diodentreiber als externe Komponente des Lasers ausgebildet sein und mit dem Laser über eine elektronische Verbindung gekoppelt sein.

Die Erfindung wird im Folgenden anhand von beispielhaften Ausführungsformen erläutert, die in den Figuren dargestellt sind. Dabei zeigen
- Fig. 1: Schematische Darstellung einer Regelung der elektromagnetischen Strahlung gemäß einer bevorzugten Ausführungsform des erfindungsgemäßen Verfahrens bzw. mittels einer bevorzugten Ausführungsform der erfindungsgemäßen Vorrichtung;
- Fig. 2: Schematische Darstellung einer Regelung der elektromagnetischen Strahlung gemäß einer bevorzugten Ausführungsform des erfindungsgemäßen Verfahrens bzw. mittels einer bevorzugten Ausführungsform der erfindungsgemäßen Vorrichtung;
- Fig. 3: Schematische Darstellung einer Regelung der elektromagnetischen Strahlung gemäß einer bevorzugten Ausführungsform des erfindungsgemäßen Verfahrens bzw. mittels einer bevorzugten Ausführungsform der erfindungsgemäßen Vorrichtung;
- Fig. 4: Schematische Darstellung einer Regelung der elektromagnetischen Strahlung gemäß einer bevorzugten Ausführungsform des erfindungsgemäßen Verfahrens bzw. mittels einer bevorzugten Ausführungsform der erfindungsgemäßen Vorrichtung;
- Fig. 5: Schematische Darstellung einer Regelung der elektromagnetischen Strahlung gemäß einer bevorzugten Ausführungsform des erfindungsgemäßen Verfahrens bzw. mittels einer bevorzugten Ausführungsform der erfindungsgemäßen Vorrichtung;
- Fig. 6: Schematische Darstellung einer Regelung der elektromagnetischen Strahlung gemäß einer bevorzugten Ausführungsform des erfindungsgemäßen Verfahrens bzw. mittels einer bevorzugten Ausführungsform der erfindungsgemäßen Vorrichtung;
- Fig. 7: Schematische Darstellung eines optischen Oszillators mit zwei Stellgrößen zum Erzeugen und Stabilisieren von elektromagnetischer Strahlung gemäß einem erfindungsgemäßen Verfahren bzw. mittels einer erfindungsgemäßen Vorrichtung;
- Fig. 8: Schematische Darstellung einer Regelung der elektromagnetischen Strahlung gemäß einer vorteilhaften Ausführungsform des erfindungsgemäßen Verfahrens bzw. mittels einer vorteilhaften Ausführungsform der erfindungsgemäßen Vorrichtung;
- Fig. 9: Schematische Darstellung einer Regelung der elektromagnetischen Strahlung gemäß einer alternativen vorteilhaften Ausführungsform des erfindungsgemäßen Verfahrens bzw. mittels einer alternativen vorteilhaften Ausführungsform der erfindungsgemäßen Vorrichtung.

Korrespondierende Komponenten sind in den Figuren und der nachstehenden detaillierten Figurenbeschreibung mit gleichen Bezugszeichen gekennzeichnet. Weiterhin werden alternative Komponenten mit einer korrespondierenden Wirkung wie die vor- und nachstehend beschriebenen Komponenten des Verfahrens zum Stabilisieren von elektromagnetischer Strahlung eines optischen Oszillators, insbesondere eines Lasers, bzw. der Vorrichtung zum Stabilisieren von elektromagnetischer Strahlung eines optischen Oszillators, insbesondere eines Lasers, gegen die vor- und nachstehend beschriebenen Komponenten desselben Verfahrens bzw. derselben Vorrichtung als austauschbar angesehen.

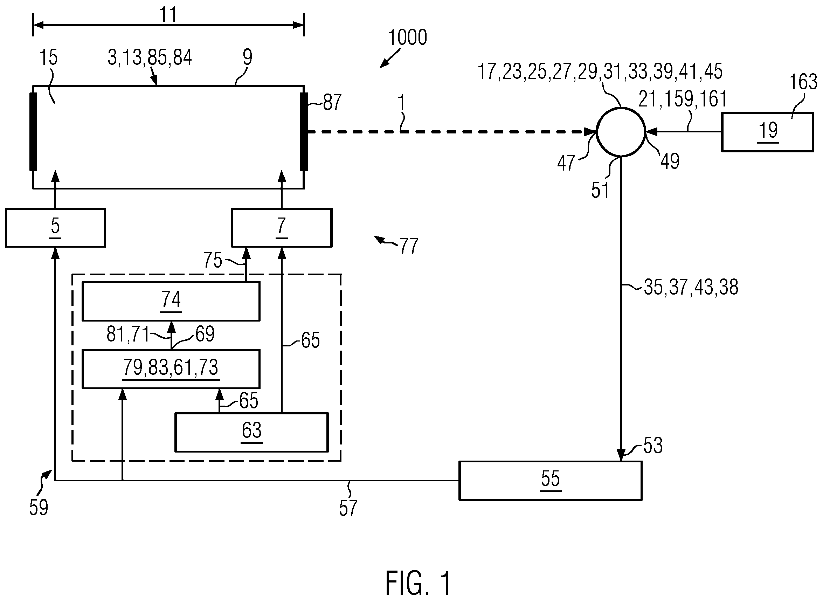

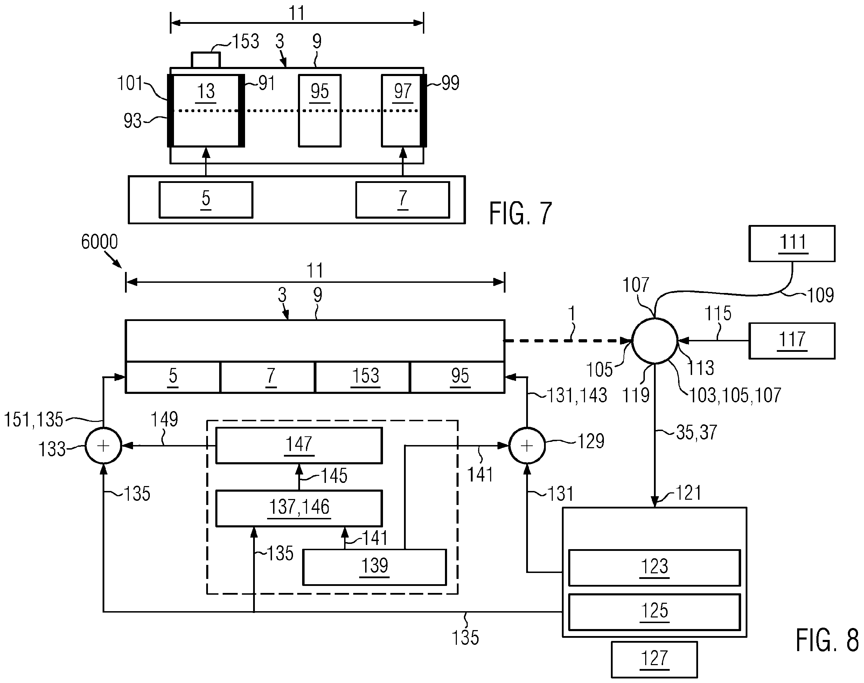

In Fig. 1 ist eine bevorzugte Ausführungsform einer erfindungsgemäßen Vorrichtung 1000 zum Stabilisieren von einer elektromagnetischer Strahlung 1 dargestellt, welche ein erfindungsgemäßes bevorzugtes Verfahren zum Stabilisieren der elektromagnetischer Strahlung 1 eines optischen Oszillators 3 ermöglichen kann. Der optische Oszillator 3 kann eine erste Stellgröße 5 sowie eine zweite Stellgröße 7 umfassen. Weiterhin kann der optische Oszillator 3 eine Kavität 9 umfassen, wobei die Kavität 9 eine Länge 11 aufweisen kann. Ein solcher optischer Oszillator 3 ist getrennt von der Vorrichtung 1000 in Fig. 7 dargestellt und kann als solcher in der Vorrichtung 1000 eingesetzt werden, wobei auch geometrisch anders angeordnete optische Oszillatoren 3 oder funktional anders angeordnete optische Oszillatoren 3 in der Vorrichtung 1000 eingesetzt werden können. Der optische Oszillator 3 kann insbesondere ein Laser sein. Der optische Oszillator 3 kann in der erfindungsgemäßen bevorzugten Vorrichtung 1000 angeordnet sein, um die elektromagnetische Strahlung 1 zu erzeugen. Hierbei kann der optische Oszillator 3 ferner einen Halbleiterlaser 13 umfassen, wobei der Halbleiterlaser 13 in einem Innenbereich 15 der Kavität 9 angeordnet sein kann. Der Halbleiterlaser 13 kann hierbei zumindest eine Mode der Kavität 9 anregen. Weiterhin kann eine Messvorrichtung 17 bereitgestellt werden, wobei die Messvorrichtung 17 dazu ausgebildet sein kann die elektromagnetische Strahlung 1 zu empfangen. Die Messvorrichtung 17 kann verschiedenartig ausgeführt sein, wie untenstehend weitergehend beschrieben.

Vorzugsweise kann die Messvorrichtung 17 einen Referenzgenerator 19 zum Erzeugen einer ersten Referenz 21 umfassen. Die erste Referenz 21 kann als ein Signal, insbesondere als ein Referenzsignal 21, ausgebildet sein. Das Referenzsignal 21 kann eine Frequenz und/oder Phase umfassen.

Weiter vorzugsweise kann die Messvorrichtung 17 als eine eigenständige Messvorrichtung für die elektromagnetische Strahlung 1 ausgebildet sein, wobei die Messvorrichtung 17 in dieser Ausbildung wie untenstehend beschrieben ausgeführt sein kann.

Wenn die Messvorrichtung 17 als eigenständige Messvorrichtung, d.h. ohne den Referenzgenerator 19, ausgeführt ist, kann ein Referenzsignal auch intern in der Messvorrichtung 17 erzeugt werden. Die als eigenständig ausgeführte Messvorrichtung 17 kann hierfür eine zweite Referenz 23 als gegenständliche Komponente umfassen. Die zweite Referenz 23 als gegenständliche Komponente kann hierbei ein Messinstrument sein oder eine weitere Komponente sein zum Analysieren, zum Messen oder zum Verarbeiten der elektromagnetischen Strahlung 1.

Wenn die Messvorrichtung 17 als eigenständige Messvorrichtung ausgeführt ist, kann die Messvorrichtung 17 dabei verschiedene frequenzselektive Elemente umfassen, insbesondere können die verschiedenen frequenzselektiven Elemente, entweder einzeln oder in Kombination, die vorgenannte zweite Referenz 23 als gegenständliche Komponente ausbilden. Vorteilhafterweise können die verschiedenen frequenzselektiven Elemente einen Resonator 25, weiter vorteilhafterweise ein atomares oder molekulares Gas 27 oder weiter vorteilhafterweise ein beliebig ausgeführtes aber für die Funktion in der Vorrichtung 1000 ausgebildetes Frequenz- oder Phasenmessinstrument 29 umfassen, insbesondere ein Wavemeter 31 oder ein Interferometer 33.

Insbesondere kann die vorstehend beschriebene Frequenzstabilisierung den Resonator 25, das atomare oder molekulare Gas 27 oder das Frequenz- oder Phasenmessinstrument 29, insbesondere das Wavemeter 31 oder das Interferometer 33, umfassen.

Vorzugsweise kann die Messvorrichtung 17 dazu ausgebildet sein, ein Phasenabweichungssignal 35 und/oder ein Frequenzabweichungssignal 37 zu erzeugen, indem die elektromagnetische Strahlung 1, insbesondere eine Phase oder Frequenz der elektromagnetischen Strahlung 3, mit der ersten Referenz 21 und/oder der zweiten Referenz 23 verglichen wird. Die zweite Referenz 23 kann hierbei eine charakteristische Frequenz 39 umfassen, etwa eine Resonanzfrequenz 41, z. B. des Resonators 25.

Das Phasenabweichungssignal 35 und/oder das Frequenzabweichungssignal 37 kann ein Signal sein, welches proportional zu einer Differenz 43 zwischen der elektromagnetischen Strahlung 1 und der ersten Referenz 21 oder der zweiten Referenz 23 sein kann, insbesondere kann die Differenz 43 zwischen der elektromagnetischen Strahlung 1 und dem Referenzsignal 23 oder der charakteristischen Frequenz 39 gebildet werden. Vorteilhafterweise kann das Phasenabweichungssignal 35 und/oder das Frequenzabweichungssignal 37 ein Signal sein, welches proportional zu einer Differenz 38 sein kann, wobei die Differenz 38 gebildet werden kann indem eine Differenz zwischen der elektromagnetischen Strahlung 1 und der ersten Referenz 21 gebildet wird und die Differenz zwischen der elektromagnetischen Strahlung 1 und der ersten Referenz 21 von der Referenz 23 subtrahiert wird. Ein Signal welches proportional zu der Differenz 38 ist, kann auch als ein erstes Abweichungssignal 38 bezeichnet werden. In einer Ausführungsform kann ein Signal welches proportional zu der Differenz 43 ist, als das erste Abweichungssignal 38 betrachtet werden. Die Differenz 38 sowie die Differenz 43 können elektromagnetische Signale sein welche jeweils eine Frequenz und eine Phase umfassen können.

Das Referenzsignal 23 kann eine Frequenz und/oder Phase umfassen, und die charakteristische Frequenz 39 kann ebenfalls eine Phase umfassen. Eine Differenz kann auch zwischen der elektromagnetischen Strahlung 1 und einer frequenzabhängigen Größe 45 der ersten Referenz 21 oder der zweiten Referenz 23 gebildet werden. Da das Phasenabweichungssignal 35 und/oder das Frequenzabweichungssignal 37 die Differenz 38 umfassen kann oder in Ausführungsformen die Differenz 43 umfassen kann, kann das Phasenabweichungssignal 35 und/oder das Frequenzabweichungssignal 37 als das erste Abweichungssignal 38 betrachten werden.

Die Messvorrichtung kann in einer bevorzugten Ausführungsform einen ersten Eingang 47, einen zweiten Eingang 49 und einen ersten Ausgang 51 umfassen. Dabei kann die elektromagnetischen Strahlung 1 in den ersten Eingang 47 eingekoppelt werden, das Referenzsignal 21 in den zweiten Eingang 49 und das Phasenabweichungssignal 35 und/oder das Frequenzabweichungssignal 37 kann an dem ersten Ausgang 51 ausgegeben werden.

Das Phasenabweichungssignal 35 und/oder das Frequenzabweichungssignal 37 kann in einen dritten Eingang 53 eines ersten Reglers 55 eingekoppelt werden. Der erste Regler 55 kann abhängig von der Form des Phasenabweichungssignals 35 und/oder des Frequenzabweichungssignals 37 zumindest ein Ausgangssignal 57 erzeugen, um eine Regelschleife 59 anzusteuern. Hierbei kann das Ausgangssignal 57 die Stellgröße 5 ansteuern, wobei die Stellgröße 5 auf den optischen Oszillator 3 einwirken kann und somit auf die elektromagnetische Strahlung 1 einwirken kann, zum Einstellen der elektromagnetischen Strahlung 1. Insbesondere kann der Regler 55 das Ausgangssignal 57 erzeugen, um einen weiteren Regler anzusteuern, wenn die Differenz 43 darauf hindeutet, dass die elektromagnetische Strahlung 1 von der Referenz 21, insbesondere dem Referenzsignal 21, abweicht oder wenn die Differenz 43 darauf hindeutet, dass die elektromagnetische Strahlung 1 von der Referenz 23, insbesondere von der charakteristischen Frequenz 39 abweicht. In einer vorteilhaften Ausführungsform kann der Regler 55 das Ausgangssignal 57 erzeugen, um einen weiteren Regler anzusteuern, wenn die Differenz 38 darauf hindeutet, dass die Differenz zwischen der elektromagnetischen Strahlung 1 und der ersten Referenz 21 von der Referenz 23 abweicht.

Die elektromagnetische Strahlung 1 muss nicht exakt mit einer Referenz übereinstimmen, sondern es kann auch eine Abweichung von einem konstanten Offset-Wert der elektromagnetischen Strahlung 1 bezüglich der Referenz betrachtet werden. Der Regler 55 kann zumindest das Ausgangssignal 57 erzeugen wenn die Differenz 43 darauf hindeutet, dass die elektromagnetische Strahlung 1 von der Referenz 23, insbesondere von der charakteristischen Frequenz 39 abweicht, oder von der Referenz 21 abweicht. In einer Ausführungsform kann der Regler 55 zumindest das Ausgangssignal 57 erzeugen, wenn die Differenz 38 darauf hindeutet, dass die Differenz zwischen der elektromagnetischen Strahlung 1 und der ersten Referenz 21 von der Referenz 23 abweicht. Dies kann insbesondere der Fall sein, wenn die Differenz 43 darauf hindeutet, dass die elektromagnetische Strahlung 1 nicht von der Referenz 21, insbesondere nicht von dem Referenzsignal 21, abweicht oder wenn die Differenz 43 darauf hindeutet, dass die elektromagnetische Strahlung 1 nicht von der Referenz 23, insbesondere nicht von der charakteristischen Frequenz 39, abweicht. Das Ausgangssignal 57 kann einen endlichen Wert umfassen, insbesondere eine endliche Amplitude umfassen, wobei das Ausgangssignal 57 aber auch null betragen kann. Das Ausgangssignal 57 kann ein elektromagnetisches Signal sein oder kann einen konstanten Strom oder eine konstante Spannung umfassen, wobei der konstante Strom auch 0 Ampere betragen kann oder die konstante Spannung auch 0 Volt betragen kann. Das Ausgangssignal 57 kann in eine Demodulationseinheit 61 eingekoppelt werden. Weiterhin kann eine Modulationseinheit 63 bereitgestellt werden, um ein Modulationssignal 65 zu erzeugen. Das Modulationssignal 65 kann der Demodulationseinheit 61 bereitgestellt werden, um an einem zweiten Ausgang 69 ein zweites Abweichungssignal 71 von einem Festwert 73 zu erzeugen. Das zweite Abweichungssignal 71 kann einem zweiten Regler 74 bereitgestellt werden, wobei der zweite Regler 74 ein Ausgangssignal 75 erzeugen kann und das Ausgangssignal 75 zusammen mit dem Modulationssignal 65 die zweite Stellgröße 7 ansteuern kann. Insbesondere kann die zweite Stellgröße 7 auf den optischen Oszillator 3 einwirken und kann somit auf die elektromagnetische Strahlung 1 einwirken, zum Einstellen der elektromagnetischen Strahlung 1. Insbesondere können die zwei Stellgrößen 5 und 7 gemeinsam auf den optischen Oszillator 3 einwirken und können somit auf die elektromagnetische Strahlung 1 einwirken, zum Einstellen der elektromagnetischen Strahlung 1. Hierbei kann die Stellgröße 5 eine Reaktionszeit umfassen, welche von der Reaktionszeit der Stellgröße 7 verschieden sein kann. Hierbei kann die Reaktionszeit eine Zeit sein, welche zwischen dem Ansteuern einer Stellgröße und dem Einwirken der Stellgröße auf den optischen Oszillator 3 vergeht. Dabei kann die Stellgröße 5 eine Reaktionszeit umfassen welche länger ist als die Reaktionszeit der Stellgröße 7. In einer Ausführungsform kann die Reaktionszeit der Stellgröße 7 aber auch länger sein als die Reaktionszeit der Stellgröße 5. Zum Stabilisieren der ersten elektromagnetischen Strahlung 1 kann nun das zweite Abweichungssignal 71 geregelt werden.

In einer Ausführungsform, welche die hier in ihrer Gesamtheit beschriebene allgemeine erfinderische Idee verfolgt, kann ein Verhältnis 77 aus einem Ansteuern von Stellgrößen 5, 7, von einem Messgerät 79 gemessen werden. Ein zweites Abweichungssignal 81 kann aus einer Abweichung des Verhältnisses 77 von einem Festwert 83 gebildet werden. Das zweite Abweichungssignal 81 kann in den zweiten Regler 74 eingekoppelt werden, so dass der zweite Regler 74 das Ausgangssignal 75 erzeugen kann. Das Ausgangssignal 75 kann zusammen mit dem Modulationssignal 65 die zweite Stellgröße 7 ansteuern. Zum Stabilisieren der ersten elektromagnetischen Strahlung 1 kann das zweite Abweichungssignal 71 geregelt werden oder kann das Verhältnis 77 geregelt werden.

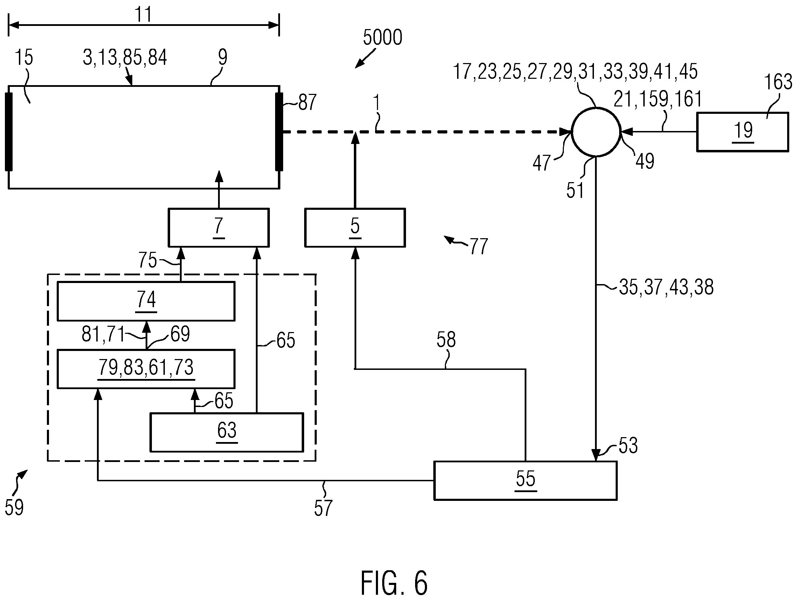

Die Stellgrößen 5 und/oder 7 können in der Kavität 9 angeordnet sein, können aber alternativ auch außerhalb der Kavität 9 angeordnet sein, wie dies in Fig. 6 dargestellt ist. In Fig. 6 ist eine weitere bevorzugte Ausführungsform dargestellt, welche von der Vorrichtung 5000 ausgebildet wird. Hierbei kann die Stellgröße 5 außerhalb der Kavität 9 angeordnet sein. Ein Regelbereich, d.h. die gesamte Regelung oder Teile der Regelung, der Vorrichtung 5000 kann wie vorstehend oder nachstehend beschrieben ausgeführt sein.

Die Stellgrößen 5 und/oder 7 können verschiedene Komponenten umfassen, um auf den optischen Oszillator 3 einzuwirken, z.B. einen Strom 84 welcher zum Betreiben des Halbleiterlasers 13 bereitgestellt werden kann, eine Temperatursteuerung 85 welche am optischen Oszillator 3 angeordnet sein kann oder zumindest einen Aktuator 87 welcher ausgeführt sein kann den optischen Oszillator 3 mechanisch zu deformieren, insbesondere geringfügig zu deformieren.

Der Aktuator 87 kann ausgeführt sein eine optische Weglänge des optischen Oszillators 3 einzustellen. Der Aktuator 87 kann als ein elektro-optischer Modulator ausgebildet sein, wobei eine an den elektro-optischen Modulator angelegte Spannung dazu ausgebildet sein kann auf den elektro-optischen Modulator einzuwirken, um die optische Weglänge des optischen Oszillators 3 einzustellen.

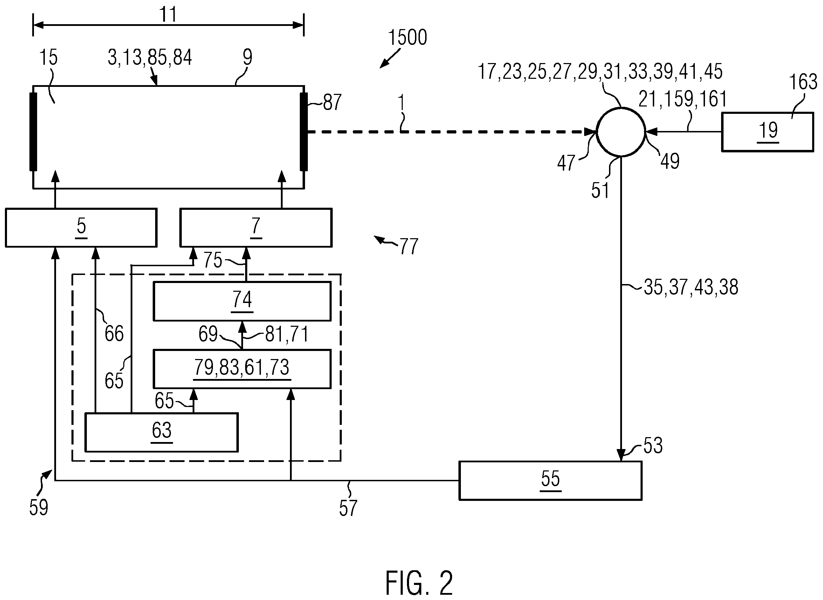

In Fig. 2 ist eine weitere bevorzugte Ausführungsform dargestellt, welche von der Vorrichtung 1500 ausgebildet wird. Die in Fig. 2 dargestellte Ausführungsform basiert auf der in Fig. 1 dargestellten Ausführungsform wobei das Modulationssignal 65 in die Stellgröße 7 und ein zweites Modulationssignal 66 in die Stellgröße 5 eingekoppelt wird. Die Modulationssignale 65 und 66 sind durch zueinander gegenphasige Signalverläufe charakterisiert. Eine Amplitude des Modulationssignals 65 und eine Amplitude des Modulationssignals 66 können eingestellt werden um einen Zielzustand der elektromagnetischen Strahlung 1 einzustellen. In dem Zielzustand kann die elektromagnetische Strahlung modulationsfrei sein. Eine Phase des Modulationssignals 65 und eine Phase des Modulationssignals 66 können eingestellt werden um einen Zielzustand der elektromagnetischen Strahlung 1 einzustellen. In dem Zielzustand kann die elektromagnetische Strahlung modulationsfrei sein.

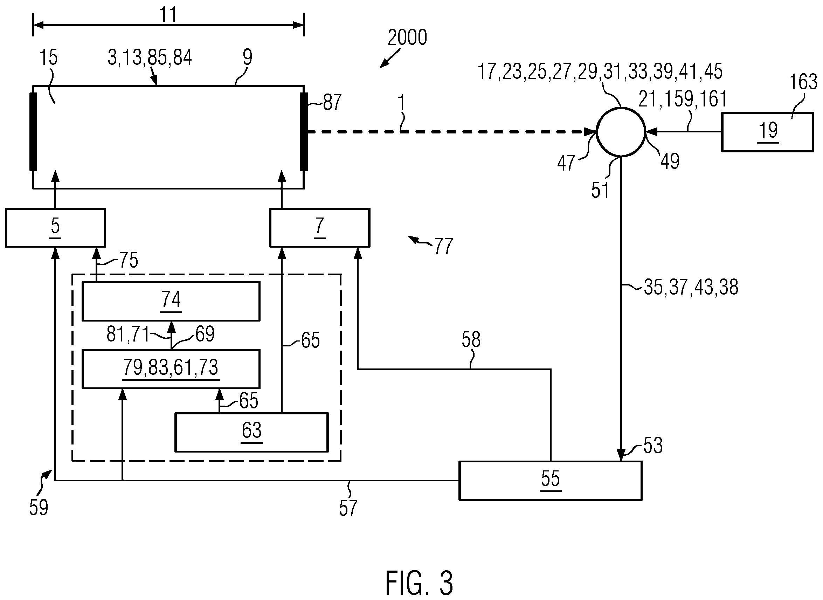

In Fig. 3 ist eine weitere bevorzugte Ausführungsform dargestellt, welche von der Vorrichtung 2000 ausgebildet wird. Im Gegensatz zu der in Fig. 1 dargestellten Ausführungsform ist die Vorrichtung 2000 ausgebildet das Ausgangssignal 75 in die Stellgröße 5 einzukoppeln zum Ansteuern der Stellgröße 5 und das Ausgangssignal 57 in die Stellgröße 7 einzukoppeln zum Ansteuern der Stellgröße 7.

Es kann vorgesehen sein das Ausgangssignal 75 entweder in die Stellgröße 5 oder in die Stellgröße 7 einzukoppeln und das Ausgangssignal 57 in die jeweils andere Stellgröße 5 oder 7einzukoppeln. Es kann vorgesehen sein das Ausgangssignal 75 und das Ausgangssignal 57 in die Stellgröße 5 einzukoppeln oder es kann vorgesehen sein das Ausgangssignal 75 und das Ausgangssignal 57 in die Stellgröße 7 einzukoppeln. Das Modulationssignal 65 kann in die Stellgröße 5 oder in die Stellgröße 7 eingekoppelt werden. Dabei kann die Stellgröße 5 eine Reaktionszeit umfassen welche länger ist als die Reaktionszeit der Stellgröße 7. In einer Ausführungsform kann die Reaktionszeit der Stellgröße 7 aber auch länger sein als die Reaktionszeit der Stellgröße 5. Der Regler 55 kann zumindest ein Ausgangssignal 57 erzeugen, welches für die vorgenannte Regelung bereitgestellt werden kann. In einer Ausführungsform kann der Regler zumindest zwei Ausgänge umfassen zum Erzeugen von einem Ausgangssignal 57 und einem Ausgangssignal 58, welche für die vorgenannte Regelung bereitgestellt werden können. Das Ausgangssignal 58 kann in die Stellgröße 5 eingekoppelt werden zum Ansteuern der Stellgröße 5 und das Ausgangssignal 57 kann in die Stellgröße 7 eingekoppelt werden zum Ansteuern der Stellgröße 7. In einer Ausführungsform kann das Ausgangssignal 58 in die Stellgröße 7 eingekoppelt werden zum Ansteuern der Stellgröße 7 und das Ausgangssignal 57 kann in die Stellgröße 5 eingekoppelt werden zum Ansteuern der Stellgröße 5.

In einer Ausführungsform, in der die Stellgröße 5 eine Reaktionszeit umfasst, welche länger ist als die Reaktionszeit der Stellgröße 7, und das Ausgangssignal 58 in die Stellgröße 5 eingekoppelt wird zum Ansteuern der Stellgröße 5 und das Ausgangssignal 57 in die Stellgröße 7 eingekoppelt wird zum Ansteuern der Stellgröße 7, kann der Regler 55 ausgebildet sein ein Ausgangssignal 58 zu erzeugen, welches eine größere Amplitude hat als das Ausgangssignal 57, insbesondere kann der Regler 55 ausgebildet sein ein Ausgangssignal 58 zu erzeugen, welches eine kleinere Frequenzbandbreite hat als das Ausgangssignal 57, insbesondere kann der Regler 55 ausgebildet sein ein Ausgangssignal 58 zu erzeugen, welches eine langsamere zeitliche Veränderung einer Amplitude und/oder Frequenz und/oder Phase aufweist als das Ausgangssignal 57.

In einer Ausführungsform, in der die Stellgröße 5 eine Reaktionszeit umfasst, welche kürzer ist als die Reaktionszeit der Stellgröße 7, und das Ausgangssignal 58 in die Stellgröße 5 eingekoppelt wird zum Ansteuern der Stellgröße 5 und das Ausgangssignal 57 in die Stellgröße 7 eingekoppelt wird zum Ansteuern der Stellgröße 7, so kann der Regler 55 ausgebildet sein ein Ausgangssignal 58 zu erzeugen, welches eine kleinere Amplitude hat als das Ausgangssignal 57, insbesondere kann der Regler 55 ausgebildet sein ein Ausgangssignal 58 zu erzeugen, welches eine größere Frequenzbandbreite hat als das Ausgangssignal 57, insbesondere kann der Regler 55 ausgebildet sein ein Ausgangssignal 58 zu erzeugen, welches eine schnellere zeitliche Veränderung einer Amplitude und/oder Frequenz und/oder Phase aufweist als das Ausgangssignal 57.

In einer Ausführungsform, in der die Stellgröße 5 eine Reaktionszeit umfasst, welche länger ist als die Reaktionszeit der Stellgröße 7, und das Ausgangssignal 57 in die Stellgröße 5 eingekoppelt wird zum Ansteuern der Stellgröße 5 und das Ausgangssignal 58 in die Stellgröße 7 eingekoppelt wird zum Ansteuern der Stellgröße 7, so kann der Regler 55 ausgebildet sein ein Ausgangssignal 57 zu erzeugen, welches eine größere Amplitude hat als das Ausgangssignal 58, insbesondere kann der Regler 55 ausgebildet sein ein Ausgangssignal 57 zu erzeugen, welches eine kleinere Frequenzbandbreite hat als das Ausgangssignal 58, insbesondere kann der Regler 55 ausgebildet sein ein Ausgangssignal 57 zu erzeugen, welches eine langsamere zeitliche Veränderung einer Amplitude und/oder Frequenz und/oder Phase aufweist als das Ausgangssignal 58.

In einer Ausführungsform, in der die Stellgröße 5 eine Reaktionszeit umfasst, welche kürzer ist als die Reaktionszeit der Stellgröße 7, und das Ausgangssignal 57 in die Stellgröße 5 eingekoppelt wird zum Ansteuern der Stellgröße 5 und das Ausgangssignal 58 in die Stellgröße 7 eingekoppelt wird zum Ansteuern der Stellgröße 7, so kann der Regler 55 ausgebildet sein ein Ausgangssignal 57 zu erzeugen, welches eine kleinere Amplitude hat als das Ausgangssignal 58, insbesondere kann der Regler 55 ausgebildet sein ein Ausgangssignal 57 zu erzeugen, welches eine größere Frequenzbandbreite hat als das Ausgangssignal 58, insbesondere kann der Regler 55 ausgebildet sein ein Ausgangssignal 57 zu erzeugen, welches eine schnellere zeitliche Veränderung einer Amplitude und/oder Frequenz und/oder Phase aufweist als das Ausgangssignal 58.

Die schon vorstehend beschriebenen Regelungsabläufe bzw. Komponenten der Vorrichtung 1000 können auch in der Vorrichtung 2000 vorgesehen sein. Ein Regelbereich, d.h. die gesamte Regelung oder Teile der Regelung, der Vorrichtung 2000 kann wie vorstehend oder nachstehend beschrieben ausgeführt sein.

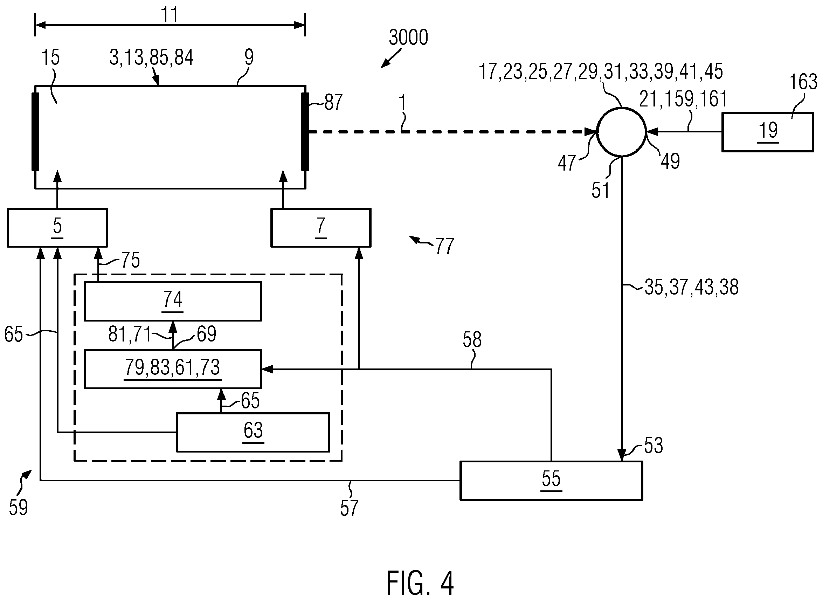

In Fig. 4 ist eine weitere bevorzugte Ausführungsform dargestellt, welche von der Vorrichtung 3000 ausgebildet wird. Hierbei kann es vorgesehen sein, eine Stellgröße, z.B. die Stellgröße 7, mit dem Ausgangssignal 58 anzusteuern. Weiterhin kann es vorgesehen sein, eine weitere Stellgröße, z.B. die Stellgröße 5, mit dem zweiten Abweichungssignal 71 oder 81 anzusteuern, sowie mit dem Ausgangssignal 57. Es kann vorgesehen sein, das Ausgangssignal 75 entweder in die Stellgröße 5 oder in die Stellgröße 7 einzukoppeln und das Ausgangssignal 57 in die jeweils andere Stellgröße 5 oder 7 einzukoppeln. Die schon vorstehend beschriebenen Regelungsabläufe bzw. Komponenten anderer Ausführungsformen, insbesondere der Vorrichtung 1000, können auch in der Vorrichtung 3000 vorgesehen sein. Ein Regelbereich, d.h. die gesamte Regelung oder Teile der Regelung, der Vorrichtung 3000 kann wie vorstehend oder nachstehend beschrieben ausgeführt sein.

Das Ausgangssignal 58 wird in die Demodulationseinheit 61 eingekoppelt. Das von der Modulationseinheit 63 erzeugte Modulationssignal 65 wird der Demodulationseinheit 61 bereitgestellt, um an dem zweiten Ausgang 69 das zweite Abweichungssignal 71 von dem Festwert 73 zu erzeugen.

Das Ausgangssignal 58 ist dazu ausgebildet, einen weiteren Regler, z.B. die Stellgröße 7, mit größerem dynamischen Bereich anzusteuern, um das Ausgangssignal 57 im Zentrum seines dynamischen Bereiches zu halten.

Der Regler 55 kann zumindest das Ausgangssignal 57 erzeugen, welches für die vorgenannte Regelung bereitgestellt werden kann. In einer Ausführungsform kann der Regler zumindest zwei Ausgänge umfassen zum Erzeugen von dem Ausgangssignal 57 und dem Ausgangssignal 58, welche für die vorgenannte Regelung bereitgestellt werden können. In einer Ausführungsform kann das Ausgangssignal 58 in die Stellgröße 5 eingekoppelt werden zum Ansteuern der Stellgröße 5 und das Ausgangssignal 57 kann in die Stellgröße 7 eingekoppelt werden zum Ansteuern der Stellgröße 7. In einer Ausführungsform kann das Ausgangssignal 58 in die Stellgröße 7 eingekoppelt werden zum Ansteuern der Stellgröße 7 und das Ausgangssignal 57 kann in die Stellgröße 5 eingekoppelt werden zum Ansteuern der Stellgröße 5.

In einer Ausführungsform, in der die Stellgröße 5 eine Reaktionszeit umfasst, welche länger ist als die Reaktionszeit der Stellgröße 7, und das Ausgangssignal 58 in die Stellgröße 5 eingekoppelt wird zum Ansteuern der Stellgröße 5 und das Ausgangssignal 57 in die Stellgröße 7 eingekoppelt wird zum Ansteuern der Stellgröße 7, kann der Regler 55 ausgebildet sein ein Ausgangssignal 58 zu erzeugen, welches eine größere Amplitude hat als das Ausgangssignal 57, insbesondere kann der Regler 55 ausgebildet sein ein Ausgangssignal 58 zu erzeugen, welches eine kleinere Frequenzbandbreite hat als das Ausgangssignal 57, insbesondere kann der Regler 55 ausgebildet sein ein Ausgangssignal 58 zu erzeugen, welches eine langsamere zeitliche Veränderung einer Amplitude und/oder Frequenz und/oder Phase aufweist als das Ausgangssignal 57.

In einer Ausführungsform, in der die Stellgröße 5 eine Reaktionszeit umfasst, welche kürzer ist als die Reaktionszeit der Stellgröße 7, und das Ausgangssignal 58 in die Stellgröße 5 eingekoppelt wird zum Ansteuern der Stellgröße 5 und das Ausgangssignal 57 in die Stellgröße 7 eingekoppelt wird zum Ansteuern der Stellgröße 7, so kann der Regler 55 ausgebildet sein ein Ausgangssignal 58 zu erzeugen, welches eine kleinere Amplitude hat als das Ausgangssignal 57, insbesondere kann der Regler 55 ausgebildet sein ein Ausgangssignal 58 zu erzeugen, welches eine größere Frequenzbandbreite hat als das Ausgangssignal 57, insbesondere kann der Regler 55 ausgebildet sein ein Ausgangssignal 58 zu erzeugen, welches eine schnellere zeitliche Veränderung einer Amplitude und/oder Frequenz und/oder Phase aufweist als das Ausgangssignal 57.

In einer Ausführungsform, in der die Stellgröße 5 eine Reaktionszeit umfasst, welche länger ist als die Reaktionszeit der Stellgröße 7, und das Ausgangssignal 57 in die Stellgröße 5 eingekoppelt wird zum Ansteuern der Stellgröße 5 und das Ausgangssignal 58 in die Stellgröße 7 eingekoppelt wird zum Ansteuern der Stellgröße 7, so kann der Regler 55 ausgebildet sein ein Ausgangssignal 57 zu erzeugen, welches eine größere Amplitude hat als das Ausgangssignal 58, insbesondere kann der Regler 55 ausgebildet sein ein Ausgangssignal 57 zu erzeugen, welches eine kleinere Frequenzbandbreite hat als das Ausgangssignal 58, insbesondere kann der Regler 55 ausgebildet sein ein Ausgangssignal 57 zu erzeugen, welches eine langsamere zeitliche Veränderung einer Amplitude und/oder Frequenz und/oder Phase aufweist als das Ausgangssignal 58.

In einer Ausführungsform, in der die Stellgröße 5 eine Reaktionszeit umfasst, welche kürzer ist als die Reaktionszeit der Stellgröße 7, und das Ausgangssignal 57 in die Stellgröße 5 eingekoppelt wird zum Ansteuern der Stellgröße 5 und das Ausgangssignal 58 in die Stellgröße 7 eingekoppelt wird zum Ansteuern der Stellgröße 7, so kann der Regler 55 ausgebildet sein ein Ausgangssignal 57 zu erzeugen, welches eine kleinere Amplitude hat als das Ausgangssignal 58, insbesondere kann der Regler 55 ausgebildet sein ein Ausgangssignal 57 zu erzeugen, welches eine größere Frequenzbandbreite hat als das Ausgangssignal 58, insbesondere kann der Regler 55 ausgebildet sein ein Ausgangssignal 57 zu erzeugen, welches eine schnellere zeitliche Veränderung einer Amplitude und/oder Frequenz und/oder Phase aufweist als das Ausgangssignal 58.

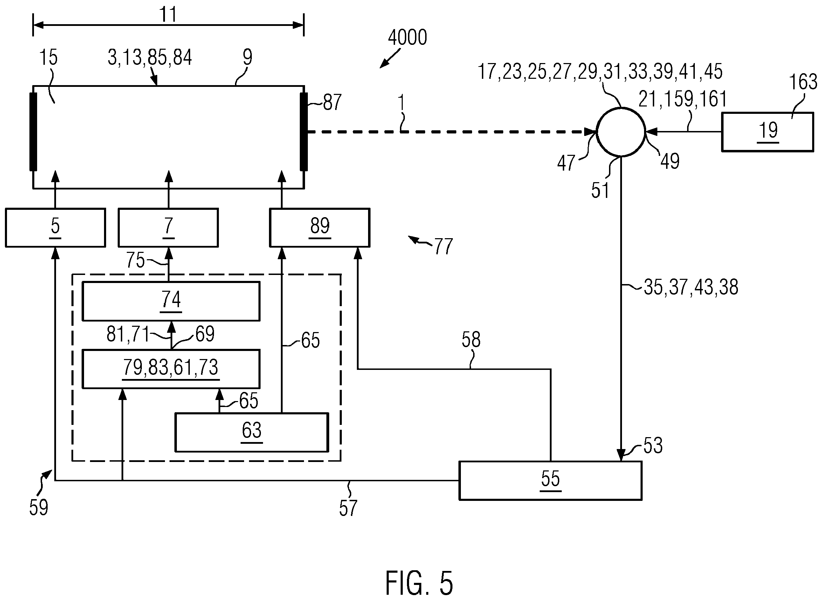

In Fig. 5 ist eine weitere bevorzugte Ausführungsform dargestellt, welche von der Vorrichtung 4000 ausgebildet wird. Hierbei kann eine dritte Stellgröße 89 bereitgestellt werden, so dass die Vorrichtung 4000 drei Stellgrößen 5, 7, 89 umfasst. Die schon vorstehend beschriebenen Regelungsabläufe bzw. Komponenten anderer Ausführungsformen, insbesondere der Vorrichtung 1000, können auch in der Vorrichtung 4000 vorgesehen sein. Ein Regelbereich, d.h. die gesamte Regelung oder Teile der Regelung, der Vorrichtung 4000 kann wie vorstehend oder nachstehend beschrieben ausgeführt sein. Das Modulationssignal 65 kann in die dritte Stellgröße 89 eingekoppelt werden, wobei das Ausgangssignal 75 in die Stellgröße 7 eingekoppelt werden kann. Es kann vorgesehen sein das Ausgangssignal 57 in die Stellgröße 5 oder 89 einzukoppeln,. Es kann vorgesehen sein das Ausgangssignal 58 in die Stellgröße 5 oder 89 einzukoppeln. Insbesondere können die drei Stellgrößen 5, 7, 89 gemeinsam auf den optischen Oszillator 3 einwirken und können somit auf die elektromagnetische Strahlung 1 einwirken, zum Einstellen der elektromagnetischen Strahlung 1. Die drei Stellgrößen 5, 7, 89 können aber auch einzeln oder in Kombination von zwei Stellgrößen auf den optischen Oszillator 3 einwirken und können somit auf die elektromagnetische Strahlung 1 einwirken, zum Einstellen der elektromagnetischen Strahlung 1.

Der Regler 55 kann zumindest ein Ausgangssignal 57 erzeugen, welches für die vorgenannte Regelung bereitgestellt werden kann. In einer Ausführungsform kann der Regler zumindest zwei Ausgänge umfassen zum Erzeugen von einem Ausgangssignal 57 und einem Ausgangssignal 58, welche für die vorgenannte Regelung bereitgestellt werden können. Das Ausgangssignal 58 kann in die Stellgröße 5 eingekoppelt werden zum Ansteuern der Stellgröße 5 und das Ausgangssignal 57 kann in die Stellgröße 89 eingekoppelt werden zum Ansteuern der Stellgröße 89. In einer Ausführungsform kann das Ausgangssignal 58 in die Stellgröße 89 eingekoppelt werden zum Ansteuern der Stellgröße 89 und das Ausgangssignal 57 kann in die Stellgröße 5 eingekoppelt werden zum Ansteuern der Stellgröße 5.

In einer Ausführungsform, in der die Stellgröße 5 eine Reaktionszeit umfasst, welche länger ist als die Reaktionszeit der Stellgröße 89, und das Ausgangssignal 58 in die Stellgröße 5 eingekoppelt wird zum Ansteuern der Stellgröße 5 und das Ausgangssignal 57 in die Stellgröße 89 eingekoppelt wird zum Ansteuern der Stellgröße 89, kann der Regler 55 ausgebildet sein ein Ausgangssignal 58 zu erzeugen, welches eine größere Amplitude hat als das Ausgangssignal 57, insbesondere kann der Regler 55 ausgebildet sein ein Ausgangssignal 58 zu erzeugen, welches eine kleinere Frequenzbandbreite hat als das Ausgangssignal 57, insbesondere kann der Regler 55 ausgebildet sein ein Ausgangssignal 58 zu erzeugen, welches eine langsamere zeitliche Veränderung einer Amplitude und/oder Frequenz und/oder Phase aufweist als das Ausgangssignal 57.

In einer Ausführungsform, in der die Stellgröße 5 eine Reaktionszeit umfasst, welche kürzer ist als die Reaktionszeit der Stellgröße 89, und das Ausgangssignal 58 in die Stellgröße 5 eingekoppelt wird zum Ansteuern der Stellgröße 5 und das Ausgangssignal 57 in die Stellgröße 89 eingekoppelt wird zum Ansteuern der Stellgröße 89, so kann der Regler 55 ausgebildet sein ein Ausgangssignal 58 zu erzeugen, welches eine kleinere Amplitude hat als das Ausgangssignal 57, insbesondere kann der Regler 55 ausgebildet sein ein Ausgangssignal 58 zu erzeugen, welches eine größere Frequenzbandbreite hat als das Ausgangssignal 57, insbesondere kann der Regler 55 ausgebildet sein ein Ausgangssignal 58 zu erzeugen, welches eine schnellere zeitliche Veränderung einer Amplitude und/oder Frequenz und/oder Phase aufweist als das Ausgangssignal 57.

In einer Ausführungsform, in der die Stellgröße 5 eine Reaktionszeit umfasst, welche länger ist als die Reaktionszeit der Stellgröße 89, und das Ausgangssignal 57 in die Stellgröße 5 eingekoppelt wird zum Ansteuern der Stellgröße 5 und das Ausgangssignal 58 in die Stellgröße 89 eingekoppelt wird zum Ansteuern der Stellgröße 89, so kann der Regler 55 ausgebildet sein ein Ausgangssignal 57 zu erzeugen, welches eine größere Amplitude hat als das Ausgangssignal 58, insbesondere kann der Regler 55 ausgebildet sein ein Ausgangssignal 57 zu erzeugen, welches eine kleinere Frequenzbandbreite hat als das Ausgangssignal 58, insbesondere kann der Regler 55 ausgebildet sein ein Ausgangssignal 57 zu erzeugen, welches eine langsamere zeitliche Veränderung einer Amplitude und/oder Frequenz und/oder Phase aufweist als das Ausgangssignal 58.

In einer Ausführungsform, in der die Stellgröße 5 eine Reaktionszeit umfasst, welche kürzer ist als die Reaktionszeit der Stellgröße 89, und das Ausgangssignal 57 in die Stellgröße 5 eingekoppelt wird zum Ansteuern der Stellgröße 5 und das Ausgangssignal 58 in die Stellgröße 89 eingekoppelt wird zum Ansteuern der Stellgröße 89, so kann der Regler 55 ausgebildet sein ein Ausgangssignal 57 zu erzeugen, welches eine kleinere Amplitude hat als das Ausgangssignal 58, insbesondere kann der Regler 55 ausgebildet sein ein Ausgangssignal 57 zu erzeugen, welches eine größere Frequenzbandbreite hat als das Ausgangssignal 58, insbesondere kann der Regler 55 ausgebildet sein ein Ausgangssignal 57 zu erzeugen, welches eine schnellere zeitliche Veränderung einer Amplitude und/oder Frequenz und/oder Phase aufweist als das Ausgangssignal 58.

In Fig. 7 ist eine Ausführungsform des optischen Oszillators 3 dargestellt, wobei der optische Oszillator 3 die erste Stellgröße 5 sowie die zweite Stellgröße 7 umfassen kann, aber auch weitere Stellgrößen umfassen kann, wie etwa die schon vorstehend beschriebene dritte Stellgröße 89 (in Fig. 7 nicht dargestellt). Weiterhin kann der optische Oszillator 3 von der Kavität 9 umschlossen sein, wobei die Kavität 9 eine Länge 11 aufweisen kann. Hierbei kann jede Komponente des optischen Oszillators 3 unabhängig von den weiteren Komponenten des optischen Oszillators 3, zusammen mit dem optischen Oszillator 3 verwendet werden. Es können aber auch mehrere der Komponenten zusammen mit dem optischen Oszillator 3 verwendet werden. Weitere Komponenten des in Fig. 7 dargestellten optischen Oszillators 3 werden nun im Zusammenhang mit der in Fig. 8 dargestellten Vorrichtung 6000 beschrieben. Die Komponenten des in Fig. 7 dargestellten optischen Oszillators 3 können in jedem optischen Oszillator 3 der hier beschriebenen Ausführungsformen verwendet werden, insbesondere in optischen Oszillatoren 3 der in Fig. 1, 2, 3, 4, 5, 6 oder 9 dargestellten Ausführungsformen.

In Fig. 8 ist eine erfindungsgemäße vorteilhafte Vorrichtung 6000 zum Stabilisieren von der elektromagnetischer Strahlung 1 des optischen Oszillators 3 dargestellt, welche ein erfindungsgemäßes vorteilhaftes Verfahren zum Stabilisieren der elektromagnetischer Strahlung 1 des optischen Oszillators 3 ermöglichen kann. Der in Fig. 8 dargestellte optische Oszillator 3 ist in einer vereinfachten Darstellung gezeigt, wobei die detaillierte Darstellung des optischen Oszillators 3 in Fig. 7 gezeigt ist. Detailliert ist allerdings nicht so zu interpretieren, dass der in Fig. 7 gezeigte optische Oszillator nicht durch weitere Komponenten erweitert werden könnte, wie etwa durch weitere Stellgrößen. Die vorteilhafte Vorrichtung 6000 umfasst zusätzliche Komponenten, wobei die Komponenten auch in den Vorrichtungen 1000, 2000, 3000, 4000 sowie 5000 vorgesehen werden können und mit den Vorrichtungen 1000, 2000, 3000, 4000 sowie 5000 in einer modularen Art und Weise kombinierbar sind. So kann beispielsweise der Halbleiterlaser 13 weitere Komponenten umfassen und/oder es kann ein Filter oder mehrere Filter in der Kavität 9 vorgesehen werden. Dies wird nun im Folgenden weitergehend beschrieben.

Hierbei kann der optische Oszillator 3 insbesondere ein Laser sein. Der optische Oszillator 3 kann in der erfindungsgemäßen Vorrichtung 6000 angeordnet sein, um die elektromagnetische Strahlung 1 zu erzeugen. Hierbei kann der optische Oszillator 3 ferner den Halbleiterlaser 13 umfassen, wobei der Halbleiterlaser 13 eine erste Fläche 91 sowie eine zweite Fläche 93 umfassen kann und der Halbleiterlaser 13 innerhalb der Kavität 9 angeordnet sein kann. Benachbart zu der ersten Fläche 91 des Halbleiterlasers 13 kann weiterhin ein verstellbarer Wellenlängenfilter 95 angeordnet sein, wobei der Wellenlängenfilter ebenfalls in der Kavität 9 angeordnet sein kann.

Der verstellbare Wellenlängenfilter 95 kann ein Volume-Holographic-Bragg-Grating (VHBG) sein, wobei der verstellbare Wellenlängenfilter 95 dazu ausgebildet sein kann, zumindest eine Wellenlänge der elektromagnetischen Strahlung 1 zu selektieren. Ein Selektieren der zumindest einen Wellenlänge der elektromagnetischen Strahlung 1 kann durch ein Verkippen des Wellenlängenfilters 95 gegenüber einer Ausbreitungsrichtung der elektromagnetischen Strahlung 1 erreicht werden. In einer Ausführungsform kann ein Selektieren der zumindest einen Wellenlänge der elektromagnetischen Strahlung 1 durch eine Regelung der Temperatur des Wellenlängenfilters 95 erreicht werden. Hierbei kann durch ein Aufheizen oder Abkühlen des Wellenlängenfilters 95 ein Ausdehnen oder ein Zusammenziehen des Wellenlängenfilters 95 erreicht werden und somit eine Transmissions- oder Reflexionseigenschaft für eine elektromagnetische Strahlung 1 einer selektierten Wellenlänge oder eines selektierten Wellenlängenkontinuums geschaffen werden, wobei die elektromagnetische Strahlung einer selektierten Wellenlänge oder eines selektierten Wellenlängenkontinuums den Wellenlängenfilter 95 zumindest teilweise durchdringen kann oder vom Wellenlängenfilter 95 zumindest teilweise reflektiert wird. Ein Wellenlängenfilter 95 kann in einer vorteilhaften Ausführungsform gegenüber einer Ausbreitungsrichtung der elektromagnetischen Strahlung 1 verkippt werden, um eine besonders vorteilhafte Möglichkeit zu schaffen ein Selektieren der zumindest einen Wellenlänge der elektromagnetischen Strahlung 1 zu erreichen. Eine Temperatur des Wellenlängenfilters 95 kann geregelt werden.

Alternativ kann der verstellbare Wellenlängenfilter 95 als ein frequenzselektives Gitter ausgebildet sein, wobei ein Selektieren der zumindest einen Wellenlänge der elektromagnetischen Strahlung 1 durch ein verkipptes frequenzselektives Gitters gegenüber der Ausbreitungsrichtung der elektromagnetischen Strahlung 1 erreicht werden kann.

In einer alternativen Ausführungsform kann der verstellbare Wellenlängenfilter 95 als ein dielektrischer Filter ausgebildet sein, wobei ein Selektieren der zumindest einen Wellenlänge der elektromagnetischen Strahlung 1 durch eine optische Weglänge des dielektrischen Filters in einer longitudinalen Richtung bezüglich der Ausbreitungsrichtung der elektromagnetischen Strahlung 1 erreicht werden kann, wobei weiterhin ein Selektieren der zumindest einen Wellenlänge der elektromagnetischen Strahlung 1 durch einen verkippten dielektrischen Filter gegenüber einer Ausbreitungsrichtung der elektromagnetischen Strahlung 1 erreicht werden kann. Die optische Weglänge des dielektrischen Filters kann mittels verkippen oder durch Temperaturänderung des dielektrischen Filters erreicht werden. Insbesondere kann die optische Weglänge des dielektrischen Filters aber auch verändert werden indem eine Temperatur des dielektrischen Filters verändert wird, die zu einer Ausdehnung oder zu einem Zusammenziehen des dielektrischen Filters führen kann und somit die optische Weglänge des dielektrischen Filters in einer longitudinalen Richtung bezüglich der Ausbreitungsrichtung der elektromagnetischen Strahlung 1 verändert werden kann. Insbesondere kann nicht nur die optische Weglänge des dielektrischen Filters über ein Variieren der Temperatur verändert werden, sondern auch optische Weglängen der vorgenannten verstellbaren Wellenlängenfilter.

Benachbart zum verstellbaren Wellenlängenfilter 95 kann ein Aktuator 97 angeordnet sein, wobei der Aktuator 97 ebenfalls in der Kavität 9 angeordnet sein kann. Insbesondere kann die Kavität 9 oder der optische Oszillator 3 durch eine erste Fläche 99 und eine zweite Fläche 101 begrenzt sein. Hierbei kann die erste Fläche 99 der Kavität 9 und/oder die zweite Fläche 101 der Kavität 9 an den Aktuator 97 gekoppelt sein, wobei in dem vorteilhaften Ausführungsbeispiel der Fig. 8 nur die erste Fläche 99 der Kavität 9 an den Aktuator 97 gekoppelt ist.

Weiterhin kann die erste Stellgröße 5 ein elektrischer Strom sein, insbesondere eine Änderung eines elektrischen Stroms, wobei der Halbleiterlaser 13 durch diesen elektrischen Strom elektronisch gepumpt werden kann. Ein Verändern des Absolutwerts des elektrischen Stroms, welcher bereitgestellt werden kann um den Halbleiterlaser 13 zu pumpen, kann zu einer Verkürzung oder einer Verlängerung der zumindest einen Wellenlänge der elektromagnetischen Strahlung 1 führen. Die Stellgröße 5 kann aber auch als eine von außen einstellbare Stromquelle verstanden werden, insbesondere ein Treiber, wobei die Stellgröße 5 an den Halbleiterlaser 13 angekoppelt sein kann. Der Aktuator 97 kann insbesondere auf einem piezoelektrischen Effekt beruhen, wobei der piezoelektrische Effekt durch eine von außen an den Aktuator 97 angelegte Spannung aktiviert werden kann. Hierbei kann also die Stellgröße 7 eine Spannungsquelle sein, z.B. ein Spannungsnetzteil, dazu ausgebildet, eine Spannung an den Aktuator 97 anzulegen. Der Aktuator 97 kann aber auch ein elektrooptischer Modulator sein. Hierbei kann der elektrooptische Modulator eine optische Vorrichtung sein, die auf einem elektrooptischen Effekt beruht, wobei der elektrooptische Effekt ermöglichen kann durch ein von außen angelegtes Signal an den elektro-optischen Modulator, auf eine Amplitude oder eine Phase der elektromagnetischen Strahlung 1 einzuwirken. In dieser Ausführungsform wäre die Stellgröße 7 das signalgebende Element zum Steuern des elektrooptischen Modulators.

Weiterhin kann in der erfindungsgemäßen Vorrichtung 6000 eine Vergleicheinheit 103 bereitgestellt werden, wobei die Vergleicheinheit 103 weiterhin einen Wellenlängenkonverter 105 sowie einen Wellenlängenkomparator 107 umfassen kann. Die Vergleicheinheit 103 kann üblicherweise einen ersten Eingang 105 umfassen, um die elektromagnetischen Strahlung 1 in die Vergleicheinheit 103 einzukoppeln. Weiterhin kann die Vergleicheinheit 103 einen zweiten Eingang 107 umfassen, um eine elektromagnetische Strahlung 109 einer ersten Referenzquelle 111 in die Vergleicheinheit 103 einzukoppeln. Weiterhin kann die Vergleicheinheit 103 einen dritten Eingang 113 umfassen, um eine elektromagnetische Strahlung 115 einer zweiten Referenzquelle 117 einzukoppeln. Schließlich kann die Vergleicheinheit 103 einen ersten Ausgang 119 umfassen, aus dem das Phasenabweichungssignal 35 und/oder das Frequenzabweichungssignal 37 ausgekoppelt werden kann. Hierbei kann das Phasenabweichungssignal 35 durch den schon vorangehend beschriebenen Phasendetektor gebildet werden. Weiterhin kann das Frequenzabweichungssignal 37 durch den schon vorangehend beschriebenen analogen Mischer erzeugt werden.

Ein Eingang 121 kann dazu ausgebildet sein, das Phasenabweichungssignal 35 und/oder das Frequenzabweichungssignal 37 zu empfangen, wobei der Eingang 121 das Phasenabweichungssignal 35 und/oder das Frequenzabweichungssignal 37 zu einem ersten Regler 123 und/oder zu einem zweiten Regler 125 weiterleiten kann. Weiterhin kann eine Regeleinheit 127 vorgesehen sein, um den ersten Regler 123 und/oder den zweiten Regler 125 anzusteuern. Weiterhin kann eine erste Überlagerungseinheit 129 dazu ausgebildet sein, ein Ausgangssignal 131 des zweiten Reglers 125 zu empfangen.

Weiterhin kann die erste Überlagerungseinheit 129 dazu ausgebildet sein, das Ausgangssignal 131 des zweiten Reglers 125 in die zweite Stellgröße 7 einzukoppeln. Somit kann also insbesondere der Aktuator 97 dazu ausgebildet sein, von dem zweiten Regler 125 angesteuert zu werden, indem das Ausgangssignal 131 des zweiten Reglers 125 von der Stellgröße 7 empfangen wird und die Stellgröße 7 wiederum den Aktuator 97 ansteuert. Eine zweite Überlagerungseinheit 133 kann dazu ausgebildet sein, ein Ausgangssignal 135 des ersten Reglers 123 zu empfangen. Hierbei kann die erste Stellgröße 5 dazu ausgebildet sein, das Ausgangssignal 135 des ersten Reglers 123 über die erste Überlagerungseinheit 133 zu empfangen. Somit kann also der Halbleiterlaser 13 von dem Ausgangssignal 135 des ersten Reglers 123 angesteuert werden, indem das Ausgangssignal 135 des ersten Reglers 123 über die erste Überlagerungseinheit 133 die Stellgröße 5 ansteuert, wobei die Stellgröße 5 den Halbleiterlaser 13 ansteuern kann.

Weiterhin kann eine Demodulationseinheit 137 bereitgestellt werden, die weiterhin dazu ausgebildet sein kann, das Ausgangssignal 135 des ersten Reglers 123 zu empfangen. Des Weiteren kann eine Modulationseinheit 139 bereitgestellt werden, welche dazu ausgebildet sein kann, eine Modulation 141 zu erzeugen, wobei die Modulation 141 ein zeitlich variierendes Signal sein kann. Insbesondere kann die erste Überlagerungseinheit 129 dazu ausgebildet sein, die Modulation 141 zu empfangen. Vorteilhafterweise kann die erste Überlagerungseinheit 129 dazu ausgebildet sein, eine Überlagerung 143 zu erzeugen, wobei die Überlagerung 143 durch die erste Überlagerungseinheit 129 aus der Modulation 141 und dem Ausgangssignal 131 des zweiten Reglers 125 gebildet werden kann. Insbesondere ist die zweite Stellgröße 7 dazu ausgebildet, die Überlagerung 143 zu empfangen. Insbesondere kann also der Aktuator 97 über die zweite Stellgröße 7 durch die Überlagerung 143 angesteuert werden.

Weiterhin kann die Demodulationseinheit 137 dazu ausgebildet sein, die Modulation 141 der Modulationseinheit 139 zu empfangen. Hierbei kann die Demodulationseinheit 137 ein Demodulationssignal 145 von einem Festwert 146 bilden. Weiterhin kann die Vorrichtung 6000 einen dritten Regler 147 umfassen, welcher dazu ausgebildet sein kann, von dem Demodulationssignal 145 angesteuert zu werden. Weiterhin kann der dritte Regler 147 dazu konfiguriert sein, ein Ausgangssignal 149 zu erzeugen. Schließlich kann die zweite Überlagerungseinheit 133 dazu konfiguriert sein, das Ausgangssignal 149 des dritten Reglers 147 zu empfangen. Insbesondere kann die zweite Überlagerungseinheit 133 dazu ausgebildet sein, eine zweite Überlagerung 151 zu erzeugen, wobei die zweite Überlagerung 151 eine Überlagerung aus dem Ausgangssignal 149 des dritten Reglers 147 und des Ausgangssignals 135 des ersten Reglers 123 sein kann.

Insbesondere kann die erste Stellgröße 5 dazu ausgebildet sein, von der zweiten Überlagerung 151 angesteuert zu werden. Der Halbleiterlaser 13 kann also von der zweiten Überlagerung 151 über die Stellgröße 5 angesteuert werden.

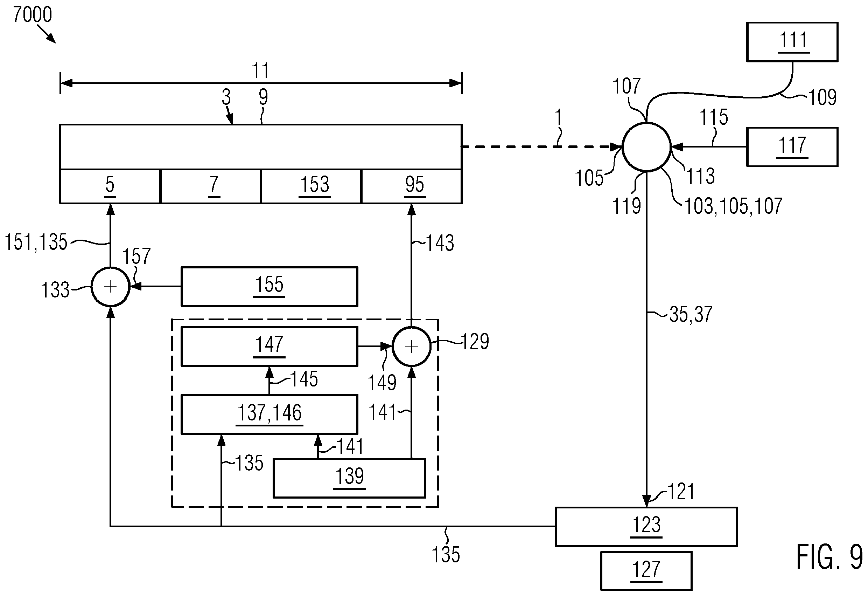

Vorteilhafterweise kann ein Temperaturelement 153 in der erfindungsgemäßen Vorrichtung 6000 vorgesehen sein, wobei das Temperaturelement 153 an die Kavität 9 gekoppelt sein kann, insbesondere kann das Temperaturelement 153 an eine äußere Wand der Kavität 9 gekoppelt sein. Hierdurch kann die Kavität 9 geheizt werden, um eine Veränderung der Länge 11 der Kavität 9 mittels einer thermischer Ausdehnung zu erreichen. Hierdurch kann die zumindest eine Wellenlänge der elektromagnetischen Strahlung 1 eingestellt werden. Insbesondere kann durch ein Heizen der Kavität 9 durch das Temperaturelement 153 hin zu einer Temperatur der Kavität 9, welche über einer Raumtemperatur liegen kann, eine Temperaturstabilisierung der Kavität 9 erreicht werden und somit auch eine Temperaturstabilisierung des optischen Oszillators 3 erreicht werden. Das Temperaturelement 153 kann auch ein Peltier-Element umfassen, womit es möglich wäre, die Kavität 7 abzukühlen, um eine Veränderung der Länge 11 der Kavität 9 mittels thermischer Kontraktion zu erreichen. Das Temperaturelement 153 kann eine weitere Stellgröße sein und kann von dem Regler 123 oder 125 angesteuert werden, obwohl dies in Fig. 8 bzw. 9 nicht explizit gezeigt ist. Der verstellbare Wellenlängenfilter 95 kann eine weitere Stellgröße sein und kann von dem Regler 123 oder 125 angesteuert werden, obwohl dies in Fig. 8 bzw. 9 nicht explizit gezeigt ist.

Zum Stabilisieren der ersten elektromagnetischen Strahlung 1 kann nun das Demodulationssignal 145 geregelt werden. Das Demodulationssignal 145 kann ein Abweichungssignal von dem Festwert 146 sein.

In Fig. 9 ist eine weitere Ausführungsform der erfindungsgemäßen Vorrichtung zum Stabilisieren von elektromagnetischer Strahlung 1 des optischen Oszillators 3 dargestellt. Diese Ausführungsform ist durch die dargestellte Vorrichtung 7000 ausgebildet. Um zu der in Fig. 9 gezeigten vorteilhaften Ausführungsform zu gelangen, kann die erfindungsgemäße vorteilhafte Vorrichtung 6000 aus Fig. 8 modifiziert werden, wobei eine Modifikation der erfindungsgemäßen vorteilhaften Vorrichtung 6000 aus Fig. 8, die Vorrichtung 6000 aus Fig. 8 ohne den zweiten Regler 123 und ohne das Ausgangssignal 131 umfassen kann und weiterhin einen Diodentreiber 155 umfassen kann, wobei der Diodentreiber 155 dazu konfiguriert sein kann ein Ausgangssignal 157 zu erzeugen, wobei das Ausgangssignal 157 eine Spannung und/oder einen Strom umfassen kann, wobei vorteilhafterweise das Ausgangssignal 157 des Diodentreibers 155 ein Spannungspuls und/oder ein Strompuls umfassen kann, wobei die Modifikation weitergehend die Überlagerungseinheit 129 umfassen kann, wobei die Überlagerungseinheit 129 dazu ausgebildet sein kann, die Modulation 141 mit dem Ausgangssignal 149 des dritten Reglers 147 zu überlagern, um zumindest eine erste Überlagerung 143 zu bilden, anstatt die zweite Überlagerungseinheit 133 dazu auszubilden das Ausgangssignal 135 des ersten Reglers 123 mit dem Ausgangssignal 149 des dritten Reglers 147 zu überlagern, um die zweite Überlagerung 151 zu bilden, wobei die Modifikation weitergehend die zweite Überlagerungseinheit 133 umfassen kann, wobei die zweite Überlagerungseinheit 133 dazu ausgebildet sein kann das Ausgangssignal 157 des Diodentreibers 155 mit dem Ausgangssignal 135 des ersten Reglers 123 zu überlagern, um die zweite Überlagerung 151 zu bilden, um die zumindest eine erste Stellgröße 5 des optischen Oszillators 3 anzusteuern.

Somit kann die in Fig. 8 dargestellte und obenstehend beschriebene erfindungsgemäße Vorrichtung 6000 zum Stabilisieren der elektromagnetischen Strahlung 1 des optischen Oszillators 3, insbesondere des Lasers, dazu verwendet werden, das erfindungsgemäße vorteilhafte Verfahren zum Stabilisieren der elektromagnetischen Strahlung 1 des optischen Oszillators 3, insbesondere des Lasers, durchzuführen.

Insbesondere kann das vorgenannte Verfahren umfassen, die elektromagnetische Strahlung 1 mit dem Halbleiterlaser 13 zu erzeugen, wobei zunächst die elektromagnetische Strahlung 1 in der Kavität 9 angeregt werden kann und die zumindest eine Wellenlänge der elektromagnetischen Strahlung 1 mittels des in der Kavität 9 angeordneten verstellbaren Wellenlängenfilters 95 selektiert werden kann. Weiterhin kann die elektromagnetische Strahlung 1 aus der teilweise für die elektromagnetische Strahlung 1 durchlässigen ersten Fläche 99 ausgekoppelt werden zum Erzeugen des Phasenabweichungssignals 35 und/oder des Frequenzabweichungssignals 37.

Hierzu kann zunächst die elektromagnetische Strahlung 1 in die Vergleicheinheit 103 eingekoppelt werden, wobei weiterhin die elektromagnetische Strahlung 109 der ersten Referenzquelle 111 ebenfalls in die Vergleicheinheit 103 eingekoppelt werden kann zum Bilden zumindest einer Frequenzdifferenz zwischen zumindest einer Frequenz der elektromagnetischen Strahlung 1 und zumindest einer Frequenz der elektromagnetischen Strahlung 109 der ersten Referenzquelle 111. Das Bilden der zumindest einen Frequenzdifferenz zwischen der zumindest einen Frequenz der elektromagnetischen Strahlung 1 und der zumindest einen Frequenz der elektromagnetischen Strahlung 109 der ersten Referenzquelle 111 kann vorteilhafterweise durch den Wellenlängenkonverter 105 ermöglicht werden, wobei der Wellenlängenkonverter 105 insbesondere ein analoger Mischer sein kann. Um das Frequenzabweichungssignal 37 zu bilden, kann der Wellenlängenkomparator 107 verwendet werden, wobei bei einem Bilden des Frequenzabweichungssignals 37 durch den Wellenlängenkomparator 107, der Wellenlängenkomparator 107 ebenfalls ein analoger Mischer sein kann. Hierzu kann der Wellenlängenkomparator bzw. der analoge Mischer 107 eine weitere Frequenzdifferenz zwischen einerseits der Frequenzdifferenz zwischen der zumindest einen Frequenz der elektromagnetischen Strahlung 1 und der zumindest einen Frequenz der elektromagnetischen Strahlung 109 der ersten Referenzquelle 111 und andererseits der zumindest einen Frequenz der elektromagnetischen Strahlung 115 der zweiten Referenzquelle 117 bilden. Die vorgenannte weitere Frequenzdifferenz zwischen einerseits der Frequenzdifferenz zwischen der zumindest einen Frequenz der elektromagnetischen Strahlung 1 und der zumindest einen Frequenz der elektromagnetischen Strahlung 109 der ersten Referenzquelle 111 und andererseits der zumindest einen Frequenz der elektromagnetischen Strahlung 115 der zweiten Referenzquelle 117 kann schließlich das Frequenzabweichungssignal 37 sein. Das Phasenabweichungssignal 35 kann im Wesentlichen wie das Frequenzabweichungssignal 37 erzeugt werden, wobei nun aber der Wellenlängenkomparator 107 der schon vorgehend beschriebene digitale Phasendetektor sein kann.

Werden nun die Regler 123 sowie 125 von dem Phasenabweichungssignal 35 und/oder dem Frequenzabweichungssignal 37 angesteuert, so kann der Regler 123 das Ausgangssignal 135 und/oder kann der Regler 125 das Ausgangssignal 131 erzeugen, zum Bilden der Überlagerung 151 und/oder der Überlagerung 143, wobei weitergehend die Überlagerung 143 und/oder die Überlagerung 151 durch eine Funktionalität der vorstehend beschriebenen Vorrichtung 6000, 7000 zum Stabilisieren der elektromagnetischen Strahlung 1 erzeugt werden kann. Die Überlagerung 143 kann hierbei die Stellgröße 7 ansteuern wobei die Überlagerung 151 die Stellgröße 5 ansteuern kann. Hiermit kann ermöglicht werden, entweder einzeln oder gleichzeitig den Aktuator 97 und/oder den Halbleiterlaser 13 zu verstellen, da die Stellgröße 5 mit dem Halbleiterlaser 13 verbunden sein und und/oder die Stellgröße 7 mit dem Aktuator 97 verbunden sein kann.

Vorteilhafterweise kann weiterhin eine Regeleinheit 127 bereitgestellt werden zum Regeln eines Verhältnisses zwischen einem Ansteuern der zweiten Stellgröße 7 und einem Ansteuern der ersten Stellgröße 5. Insbesondere kann die Regeleinheit 127 den ersten Regler 123 und/oder den zweiten Regler 125 ansteuern. Die Regeleinheit 127 kann hierzu eine Feedback-Schleife umfassen, wobei die Feedback-Schleife der Regeleinheit 127 dazu ausgelegt sein kann, das Phasenabweichungssignal 35 und/oder das Frequenzabweichungssignal 37 zu minimieren oder auf zumindest einen festgelegten Wert des Phasenabweichungssignals 35 zu regeln und/oder auf zumindest einen festgelegten Wert des Frequenzabweichungssignals 37 zu regeln. Hierzu kann das Phasenabweichungssignal 35 und/oder das Frequenzabweichungssignal 37 von der Regeleinheit 127 gemessen werden. Weitergehend kann die Regeleinheit 127 den ersten Regler 123 und/oder den zweiten Regler 125 ansteuern, zum Minimieren des Phasenabweichungssignals 35 und/oder des Frequenzabweichungssignals 37 oder zum Regeln des Phasenabweichungssignals 35 und/oder des Frequenzabweichungssignals 37 auf einen festgelegten Wert.

Weiterhin kann die in Fig. 9 dargestellte und obenstehend beschriebene erfindungsgemäße weitere Ausführungsform der Vorrichtung 7000 zum Stabilisieren der elektromagnetischen Strahlung 1 des optischen Oszillators 3, insbesondere des Lasers, dazu verwendet werden, eine erfindungsgemäße Ausführungsform eines Verfahrens zum Stabilisieren der elektromagnetischen Strahlung 1 des optischen Oszillators 3, insbesondere des Lasers, durchzuführen.

Hierbei kann das erfindungsgemäße Verfahren, welches mittels der in Fig. 8 gezeigten Vorrichtung 6000 durchgeführt werden kann, modifiziert werden, um zu dem Verfahren zu gelangen, welches mit der in Fig. 9 gezeigten Ausführungsform der Vorrichtung 7000 durchgeführt werden kann. Hierbei kann eine Modifikation des erfindungsgemäßen Verfahrens umfassen, den zweiten Regler 125 zu deaktivieren, zum Ausschalten des Ausgangssignals 131, und einen Diodentreiber 155 bereitzustellen, sowie das Ausgangssignal 149 des dritten Reglers 147 mit der Modulation 141 zu überlagern, zum Bilden der ersten Überlagerung 143, anstatt das Ausgangssignal 149 des dritten Reglers 147 mit dem Ausgangssignal 135 des ersten Reglers 123 zu überlagern, zum Bilden der zweiten Überlagerung 151, wobei weiterhin ein Ausgangssignal 157 des Diodentreibers 155 mit dem Ausgangssignal 135 des ersten Reglers 123 überlagert werden kann, zum Bilden der zweiten Überlagerung 151, zum Ansteuern der zumindest einen ersten Stellgröße 5 des optischen Oszillators 3, wobei das Ausgangssignal 157 des Diodentreibers 155 eine Spannung und/oder ein Strom umfassen kann, wobei vorteilhafterweise das Ausgangssignal 157 des Diodentreibers 155 ein Spannungspuls und/oder ein Strompuls umfassen kann.

Die schon vorstehend beschriebenen Verfahrensschritte sind aber ansonsten auch auf die in Fig. 9 gezeigte weitere Ausführungsform der Vorrichtung 7000 anwendbar.

Sowohl in der in Fig. 8 gezeigten Vorrichtung 6000 als auch in der in Fig. 9 gezeigten Ausführungsform der Vorrichtung 7000 kann zumindest der Aktuator 97 dafür vorgesehen sein, einen Dynamikbereich der Regelung zu vergrößern, indem zumindest der Aktuator 97 dafür vorgesehen sein kann, einen großen Frequenz und/oder Phasenhub zu realisieren.

Die in den Fig. 8 und 9 gezeigten Vorrichtungen können Komponenten, insbesondere elektronische Komponenten, umfassen, die analoge Schaltungskomponenten umfassen, wobei die Komponenten aber auch digitale Schaltungskomponenten umfassen können. Ebenso können die Komponenten sowohl analoge wie auch digitale Schaltungskomponenten umfassen. Ebenso können analoge Schaltungskomponenten gegen digitale Schaltungskomponenten ausgetauscht werden oder umgekehrt digitale Schaltungskomponenten gegen analoge Schaltungskomponenten ausgetauscht werden. Dies kann zum einen ermöglichen ein Rauschen in der vorgenannten Regelung zu unterdrücken, um eine verlässliche Regelung mit der Vorrichtung zu ermöglichen. So kann zusätzlich zu dem Wellenlängenkomparator 107, der als digitaler Phasendetektor ausgeführt sein kann, auch der Wellenlängenkonverter 105 anstatt als analoger Mischer, als digitaler Mischer ausgeführt sein. Der Wellenlängenkomparator 107 sowie der Wellenlängenkonverter 105 können somit als vollständig digitale Schaltungen ausgeführt werden und beispielsweise mittels einer Logik auf einem einzelnen Chip realisiert werden, z.B. auf einem Field Programmable Gate Array (FPGA) Chip. So kann, bis auf die Stellgrößen 5 sowie 7 und den optischen Oszillator 3, die vorgenannte Regelung mittels eines FPGA-Chips realisiert werden. Eine Logik auf dem FPGA-Chip kann aber Ausgangssignale bereitstellen, um die Stellgrößen 5 sowie 7 anzusteuern oder zu regeln. Die Stellgrößen 5 sowie 7 können aber auch so vorgesehen werden, dass diese ebenfalls mittels der Logik auf dem FPGA-Chip bereitgestellt werden können. Der FPGA-Chip kann weiterhin eine Schaltung umfassen, wobei die Schaltung optische Schnittstellen bereitstellen kann, damit die elektromagnetische Strahlung 107 der ersten Referenzquelle 111 in den FPGA-Chip eingekoppelt werden kann und auch die elektromagnetische Strahlung 1 des optischen Oszillators 3 in den FPGA-Chip eingekoppelt werden kann. Die zweite Referenzquelle 117 kann beispielsweise als spannungskontrollierter Oszillator ausgeführt werden. Die vorgenannte Regelung ist nicht nur auf einen Halbleiterlaser beschränkt, sondern auf beliebige Oszillatoren, welche ein regelbares Ausgangssignal umfassen oder welche ein anderes regelbares und zu stabilisierendes Signal bereitstellen.

## Patentansprüche

1. Verfahren zum Stabilisieren von einer ersten elektromagnetischen Strahlung (1) eines optischen Oszillators (3), insbesondere eines ersten Lasers (13), umfassend,
Messen einer Abweichung (35, 37, 43, 38) zwischen der ersten elektromagnetischen Strahlung (1) des optischen Oszillators (3) und einer Referenz (21, 23, 39, 41, 115) und Erzeugen eines ersten Abweichungssignals (35, 37, 43, 38),
Ansteuern eines ersten Reglers (55, 123) mit dem ersten Abweichungssignal (35, 37, 43, 38),
Regeln des ersten Abweichungssignals (35, 37, 43, 38) mittels Ansteuerung zumindest einer ersten Stellgröße (5, 7, 89) von zumindest zwei Stellgrößen (5, 7, 89), wobei die erste Stellgröße (5, 7, 89) durch ein erstes Ausgangssignal (57, 135) des ersten Reglers (55, 123) angesteuert wird und die erste Stellgröße (5, 7, 89) auf die erste elektromagnetische Strahlung (1) des optischen Oszillators (3) einwirkt,
**gekennzeichnet durch**
Erzeugen eines Modulationssignals (65, 141) mit einer Modulationseinheit (63, 139), und Ansteuern der ersten oder einer zweiten Stellgröße (5, 7, 89) mit dem Modulationssignal (65, 141),
Demodulieren des ersten Ausgangssignals (57, 135) des ersten Reglers (55, 123) mit dem Modulationssignal (65, 141) und Erzeugen eines zweiten Abweichungssignals (71, 145) von einem Festwert (73, 146),
Ansteuern eines zweiten Reglers (74, 147) mit dem zweiten Abweichungssignal (71, 145),
Ansteuern einer der Stellgrößen (5, 7, 89) mit einem Ausgangssignal (75, 149) des zweiten Reglers (74, 147) und Regeln des zweiten Abweichungssignals (71, 145).

2. Verfahren nach Anspruch 1, wobei die Abweichung (35, 37, 38, 43) minimiert wird.

3. Verfahren nach einem der Ansprüche 1 oder 2, umfassend,
Erzeugen eines zweiten Modulationssignals (66) mit der Modulationseinheit (63), und Ansteuern der anderen der ersten und der zweiten Stellgröße (5, 7, 89) mit dem zweiten Modulationssignal (66), wobei insbesondere Wirkungen des Modulationssignals (65) und des zweiten Modulationssignals (66) auf die erste elektromagnetische Strahlung (1) zueinander gegenphasig sind,
Einstellen einer Phase und/oder einer Amplitude des Modulationssignals (65) sowie Einstellen einer Phase und/oder einer Amplitude des zweiten Modulationssignals (66), zum modulationsfreien Bereitstellen der ersten elektromagnetischen Strahlung (1).

4. Verfahren nach Anspruch 1 oder 2, wobei die Referenz (21, 23, 39, 41, 115) eine Radiofrequenzreferenz (159) und eine zweite elektromagnetische Strahlung (161, 109) eines zweiten Lasers (163, 111) umfasst und die Abweichung (35, 37, 38, 43) als Differenz zwischen einerseits einer Differenz der ersten elektromagnetischen Strahlung (1) und der zweiten elektromagnetischen Strahlung (161, 109), und andererseits der Radiofrequenzreferenz (159) gebildet wird.

5. Verfahren nach einem der vorangehenden Ansprüche, wobei die Abweichung (35, 37, 38, 43) eine Frequenzabweichung (37, 43) oder eine Phasenabweichung (35, 43) umfasst.

6. Verfahren nach Anspruch 1, wobei die Referenz (23) einen Resonator (25) umfasst und die Abweichung (35, 37, 38, 43) eine Frequenzabweichung (37, 43) oder eine Phasenabweichung (35, 43) zwischen einer Frequenz oder Phase der ersten elektromagnetischen Strahlung (1) und einer Frequenz oder Phase des Resonators (25) umfasst,
wobei vorzugsweise der Resonator (25) eine Güte in einem Bereich zwischen 10000 und 1000000 umfasst, wobei die Güte gleich einer Frequenz des Resonators (25) dividiert durch eine Frequenzbandbreite des Resonators (25) ist.

7. Verfahren nach Anspruch 6, wobei der Resonator (25) ein Etalon umfasst, insbesondere ein Fabry-Perot-Etalon.

8. Verfahren nach Anspruch 1, wobei die Referenz (23) ein atomares oder molekulares Gas (27) umfasst und die Abweichung (35, 37, 38, 43) eine Frequenzabweichung (37, 43) oder eine Phasenabweichung (35, 43) zwischen einer Frequenz oder Phase der ersten elektromagnetischen Strahlung (1) und einer Frequenz oder Phase einer Resonanz des atomaren oder molekularen Gases (27) umfasst.

9. Verfahren nach Anspruch 1, wobei die Referenz (23) ein Frequenz- oder Phasenmessinstrument (29, 31, 33) umfasst, insbesondere ein Wavemeter (31) oder ein Interferometer (33), und die Abweichung (35, 37, 38, 43) eine Frequenzabweichung (37, 43) oder eine Phasenabweichung (35, 43) zwischen einer Frequenz oder Phase der ersten elektromagnetischen Strahlung (1) und einer Frequenz oder Phase des Frequenz- oder Phasenmessinstruments (29, 31, 33) umfasst.

10. Verfahren nach einem der vorangehenden Ansprüche, wobei der optische Oszillator (3) die Stellgrößen (5, 7, 89) umfasst und einen Halbleiterlaser (13) umfasst, insbesondere einen Diodenlaser (13), und die Stellgrößen einen Diodenstrom (5, 7, 89) des Diodenlasers umfassen und/oder die Diodentemperatur (5, 7, 89) des Diodenlasers (13) umfassen.

11. Verfahren nach einem der vorangehenden Ansprüche, wobei der optische Oszillator (3) eine erste Fläche (99) und eine zweite Fläche (101) umfasst, wobei zumindest die erste Fläche (99) oder die zweite Fläche (101) teilweise durchlässig für die erste elektromagnetische Strahlung (1) ist, wobei insbesondere der optische Oszillator (3) einen verstellbaren Wellenlängenfilter (95) umfasst, zum Selektieren zumindest einer Wellenlänge der ersten elektromagnetischen Strahlung (1),
wobei vorzugsweise die Stellgrößen (5, 7, 89) zumindest einen Piezoaktuator umfassen, der an die erste Fläche (99) und/oder die zweite Fläche (101) gekoppelt ist, um eine Kraft auf die erste Fläche (99) und/oder die zweite Fläche (101) auszuüben, um die Frequenz oder Phase der ersten elektromagnetischen Strahlung (1) einzustellen.

12. Verfahren nach einem der Ansprüche 6 bis 11, wobei die Stellgrößen (5, 7, 89) zumindest einen elektro-optischen Modulator umfassen, der in einem Strahlweg des optischen Oszillators (3) angeordnet ist, um die Frequenz oder Phase der ersten elektromagnetischen Strahlung (1) einzustellen.

13. Verfahren nach einem der vorangehenden Ansprüche, wobei die Stellgrößen (5, 7, 89) den verstellbaren Wellenlängenfilter (95) umfassen und dazu ausgebildet sind, den verstellbaren Wellenlängenfilter (95) einzustellen, oder wobei sich wenigstens eine der Stellgrößen (5, 7, 89) außerhalb des optischen Oszillators (3) befindet und einen akustooptischen Modulator oder einen Frequenzschieber umfasst.

14. Regelungsvorrichtung (1000, 2000, 3000, 4000, 5000, 6000, 7000) zum Stabilisieren von einer ersten elektromagnetischer Strahlung (1) eines optischen Oszillators (3), insbesondere eines ersten Lasers (13), umfassend,
eine Messvorrichtung (17, 107),
einen Referenzgenerator (19, 117) zum Erzeugen einer Referenz (21, 115),
einen ersten Regler (55, 123),
einen zweiten Regler (74, 147, 155),
wobei die Messvorrichtung (17, 107) zum Messen einer Abweichung (35, 37, 38, 43) zwischen der ersten elektromagnetischen Strahlung (1) des optischen Oszillators (3) und der Referenz (21) ausgebildet ist,
wobei der erste Regler (55, 123, 127) dazu ausgebildet ist, von einem ersten Abweichungssignal (35, 37, 43) angesteuert zu werden und das Abweichungssignal (35, 37, 38, 43) über eine Ansteuerung zumindest einer ersten Stellgröße (5, 7, 89) von zumindest zwei Stellgrö-ßen (5, 7, 89) mit einem ersten Ausgangssignal (57, 131, 135, 143, 151) zu regeln,
**gekennzeichnet durch**
eine Modulationseinheit (63, 139), welche dazu ausgebildet ist, die erste oder eine zweite Stellgröße (5, 7, 89) mit einem Modulationssignal (65, 141) anzusteuern,
eine Demodulationseinheit (61, 137), welche dazu ausgebildet ist, das erste Ausgangssignal (57, 135, 131) des ersten Reglers (55, 123) mit dem Modulationssignal (65, 141) zu demodulieren und ein zweites Abweichungssignal (71, 145) von einem Festwert (73, 146) zu erzeugen,
den zweiten Regler (74, 147, 155), welcher dazu ausgebildet ist, von dem zweiten Abweichungssignal (71, 145) angesteuert zu werden und eine der Stellgrößen (5, 7, 89) mit einem Ausgangssignal (75, 149, 157, 151) anzusteuern, um das zweite Abweichungssignal (71, 145) zu regeln.

15. Verfahren zum Stabilisieren von einer ersten elektromagnetischen Strahlung (1) eines optischen Oszillators (3), insbesondere eines ersten Lasers (13), umfassend,
Messen einer Abweichung (35, 37, 38, 43) zwischen der ersten elektromagnetischen Strahlung (1) des optischen Oszillators (3) und einer Referenz (21, 23, 39, 41) und Erzeugen eines ersten Abweichungssignals (35, 37, 38, 43),
Ansteuern eines ersten Reglers (55) mit dem ersten Abweichungssignal (35, 37, 38, 43),
Regeln des ersten Abweichungssignals (35, 37, 38, 43) mittels Ansteuerung zumindest einer ersten Stellgröße (5, 7, 89) von zumindest zwei Stellgrößen (5, 7, 89), wobei die erste Stellgröße (5, 7, 89) durch ein erstes Ausgangssignal (57) des ersten Reglers (55) angesteuert wird und die erste Stellgröße (5, 7, 89) auf die erste elektromagnetische Strahlung (1) des optischen Oszillators (3) einwirkt,
**gekennzeichnet durch**
Messen eines Modulationsindex (77), insbesondere eines Frequenz- und/oder Phasenmodulationsindex, zumindest einer der Stellgrößen (5, 7, 89) und Bilden eines zweiten Abweichungssignals (81) aus einer Abweichung des Modulationsindex (77) von einem Festwert (83),
Ansteuern eines zweiten Reglers (74) mit dem zweiten Abweichungssignal (81),
Ansteuern einer der Stellgrößen (5, 7, 89) mit einem Ausgangssignal (75) des zweiten Reglers (74) und Regeln des zweiten Abweichungssignals (81) oder des Modulationsindex (77), wobei der Modulationsindex (77) ein Verhältnis aus dem Ansteuern zumindest einer der Stellgrößen (5, 7, 89) und der Wirkung der zumindest einen Stellgröße (5, 7, 89) auf die erste elektromagnetische Strahlung (1) ist.

16. Verfahren nach Anspruch 15, umfassend,
Erzeugen eines Modulationssignals (65, 141) mit einer Modulationseinheit (63, 139), und Ansteuern der ersten oder einer zweiten Stellgröße (5, 7, 89) mit dem Modulationssignal (65, 141),
vorzugsweise ferner umfassend,
Erzeugen eines zweiten Modulationssignals (66) mit der Modulationseinheit (63), und Ansteuern der anderen der ersten und der zweiten Stellgröße (5, 7, 89) mit dem zweiten Modulationssignal (66), insbesondere, wobei eine Wirkung des Modulationssignals (65) auf die erste elektromagnetische Strahlung (1) und eine Wirkung des zweiten Modulationssignals (66) auf die erste elektromagnetische Strahlung (1) zueinander gegenphasig sind,
Einstellen einer Phase und/oder einer Amplitude des Modulationssignals (65) sowie Einstellen einer Phase und/oder einer Amplitude des zweiten Modulationssignals (66), zum modulationsfreien Bereitstellen der ersten elektromagnetischen Strahlung (1).
